# EUROPEAN PATENT APPLICATION

(11) **EP 4 109 509 A2**
(43) Date of publication of application: **28.12.2022**
(21) Application number: 22179407.6
(22) Date of filing: 16.06.2022
(51) Int. Cl.: H01L 21/78, B81C 1/00

(54) **ULTRA-THIN SEMICONDUCTOR DIE WITH IRREGULAR TEXTURED SURFACES**

(30) Priority: 24.06.2021 US 202117357826
(71) Applicant: STMicroelectronics S.r.l., 20864 Agrate Brianza (MB) (IT)
(72) Inventor: AZPEITIA URQUIA, Mikel, 20128 MILANO (IT); TENTORI, Lorenzo, 20843 VERANO BRIANZA (MB) (IT)
(74) Representative: Studio Torta S.p.A.

(57) **Abstract**

The semiconductor device comprises a die including a sidewall (150; 228; 238, 240, 242, 244; 258) having a uniform surface (186; 230; 238, 240; 260, 262) and an irregular surface (188: 232; 242, 244; 264),. The irregular surface has a more irregular texture as compared to the uniform surface. The die is obtained by pre-forming a cavity in a substrate and forming a multilayer structure on the substrate. The multilayer structure includes an active area that is aligned with and overlies the cavity. At least one recess is formed extending into the multilayer structure to the cavity. Forming the recess forms a die structure suspended above the cavity and an extension extending from the die structure to a suspension structure surrounding the die structure. The die structure is released from the die suspension structure by breaking the extension.

## Description

The present invention is directed to an ultra-thin semiconductor die including surfaces with an irregular texture and a method of manufacturing the semiconductor die using silicon on nothing or a cavity.

Generally, semiconductor device packages, such as chip scale packages or wafer level chip scale packages (WLCSPs), contain at least one integrated circuit die encased in a molding compound. The integrated circuit die may be a sensor configured to detect any number of quantities or qualities, or the integrated circuit die may be a controller such as a microprocessor or a memory utilized to control other various electronic components in or outside the semiconductor device packages. For example, the integrated circuit die may detect light, temperature, pressure, stress, strain, sound or any other type of quantities or qualities.

A conventional integrated circuit die may include a plurality of active components present within an active area of the conventional integrated circuit die. This active area is generally a combination of a plurality of dielectric layers, insulating layers, and conductive layers. The active area may include active components (e.g., transistors, diodes, etc.) and passive components (*e*.*g*., resistors, capacitors, etc.). Generally, these layers of the active area are formed on a substrate, which is generally a portion of a wafer that is utilized to form a plurality of conventional integrated circuit die. Conventional integrated circuit die generally have a thickness ranging from 50 to 800micrometers (µm).

Conventional integrated circuit die are generally formed by first forming the plurality of dielectric layers, insulating layers, and conductive layers on a first surface of the wafer. After formation of these layers, there may be some additional processing steps before a second surface of the wafer is ground down to thin the wafer. The grinding of the wafer generally happens at a back-end of the manufacturing process. Once the wafer is thinned by the grinding process, the wafer and the various layers on the wafer are singulated into individual ones of conventional integrated circuit die by a singulation step. In the singulation step, a sawing tool, a cutting tool, or a laser tool may be utilized to singulate the wafer into conventional integrated circuit die.

However, the presence of dedicated grinding and dicing steps is costly, does not allow very thin substrates to be obtained and may be problematic in some cases.

Therefore, it is an aim of the present invention to provide a semiconductor device and a process that overcome the drawbacks of the prior art.

According to the invention, a semiconductor device and a manufacturing process are provided, as defined in the attached claims.

The present disclosure illustrates embodiments of an ultra-thin semiconductor die including surfaces that are irregularly textured at which semiconductor dice are broken away from a substrate during a method of manufacturing the semiconductor die. The substrate is a wafer that includes a plurality of cavities or openings aligned with each die. The semiconductor die may have a thickness in the range of 10-30 micrometers, for example, the thickness may be substantially equal or less than 10 micrometers (µm).

In practice, An array of active areas are formed on a substrate by forming a multilayer structure, which may include dielectric layers, conductive layers, insulating layers, passivation layers, and repassivation layers stacked on a surface of the substrate. After the active areas are formed, a plurality of recesses are formed extending into the substrate around individual ones of the active areas to pre-formed cavities that are buried within the substrate. The wafer with these cavities or openings may be referred to as a silicon-on-nothing (SON) wafer.

After the recesses are formed extending to the pre-formed cavity, a plurality of lateral extensions remain coupling the semiconductor die to the substrate, and each one of the plurality of semiconductor dice overlaps a corresponding one of the pre-formed cavities within the substrate. These plurality of extensions are quasi-release structures that are to be broken, breaking away the plurality of semiconductor dice from the substrate. Each one of the plurality of semiconductor dice is suspended over a corresponding one of the pre-formed cavities within the substrate.

After the recesses are formed, the semiconductor dice may undergo further processing steps before being broken away from the substrate to further refine and complete the semiconductor die. However, once these further processing steps are performed and completed, the extension portions coupling the semiconductor dice and the substrate are broken, releasing or breaking away the semiconductor dice from the substrate. The breaking of these extension portions forms first surfaces of the semiconductor dice having a more irregular texture as compared to second surfaces of the semiconductor dice, which are formed from the etching or releasing steps. These first and second surfaces are along sidewalls of ones of the plurality of semiconductor dice. The extension portions may be broken by utilizing a pick and place machine to pick up the semiconductor dice and break the extension between the semiconductor dice and the substrate. The completed semiconductor dice may then be incorporated into semiconductor packages or electronic devices.

In some cases, the plurality of semiconductor die are completed after the multilayer structure is formed. In this case, the plurality of completed semiconductor dice are then broken away from the substrate after the multilayer structure is formed.

The substrate may be singulated while the plurality of semiconductor dice are still coupled to the substrate. The substrate may be singulated such that each of the plurality of semiconductor dice remain coupled to a portion of the substrate after singulating the substrate to form die structure assemblies.

The recesses may be formed at a front-end of the method of manufacturing. For example, the recesses may be formed before further refining steps are performed to further refine and complete the semiconductor die.

For a better understanding of the embodiments, reference will now be made by way of example to the accompanying drawings. In the drawings, identical reference numbers identify the same or similar elements or acts. The sizes and relative proportions of the elements in the drawings are not necessarily drawn to scale. For example, some of these elements may be enlarged and positioned to improve drawing legibility.
Figure 1A is a cross-section taken along line A-A of Figure 1B showing the die as shown in Figures IE and IF in a manufacturing step;
Figure 1B is a top plan view of Figure 1A;
Figure 1C is a cross-section similar to Figure 1A showing in a subsequent manufacturing step;
Figure 1D is a top plan view of Figure 1C;
Figure IE is a top plan view of a die formed by the method of manufacturing as shown in Figures 1A-1D;
Figure IF is a side view of the semiconductor die as shown in Figure IE;
Figure 2A is a top plan view of a first die structure assembly;
Figure 2B is a cross-sectional view of the first die structure assembly 1taken along line B-B in Figure 2A;
Figure 3 shows an alternative embodiment of a die structure assembly;
Figure 4 shows an alternative embodiment of a die structure assembly;
Figure 5 is shows an alternative embodiment of a die structure assembly;
Figure 6 is a top plan view of an alternative embodiment of a die;
Figure 7 is a top plan view of an alternative embodiment of a die;
Figure 8 is a top plan view of an alternative embodiment of a die;
Figures 9A-9C are cross-sectional views of an alternative embodiment of a method of manufacturing to form an alternative embodiment of a die;
Figures 10A and 10B are cross-sectional views of an alternative embodiment of a method of manufacturing an alternative embodiment of a die;
Figure 11a top plan view of an alternative embodiment of a die structure assembly;
Figure 12 is a top plan view of an alternative embodiment of a die structure assembly;
Figures 13A is a top plan view of an alternative embodiment of a die structure assembly;
Figure 13B is a cross-sectional view of the alternative embodiment of the die structure assembly taken along line C-C as shown in Figure 13A; and
Figure 14 is a cross-sectional view of a method of manufacturing an alternative embodiment of a die.

The terms "top," "bottom," "upper," "lower," "left," and "right," are used for only discussion purposes based on the orientation of the components in the discussion of the Figures in the present disclosure as follows.

The term "substantially" is used to clarify that there may be slight differences and variation when a package is manufactured in the real world, as nothing can be made perfectly equal or perfectly the same. In other words, "substantially" means and represents that there may be some slight variation in actual practice and instead is made or manufactured within selected tolerances.

The present disclosure illustrates completed semiconductor dice, which may be ultra-thin semiconductor dice having a thickness in the range of 10-30 micrometers (µm). Alternatively, the thickness of ultra-thin semiconductor die may be substantially equal to or less than 10 micrometers (µm).

The completed semiconductor die includes surfaces that are irregularly textured at locations at which the semiconductor dice are broken away from a substrate, which may be a wafer, during a method of manufacturing the semiconductor die.

The wafer includes a plurality of cavities or openings aligned with each of the semiconductor dice to be formed utilizing the wafer.

The wafer may be referred to as a silicon-on-nothing (SON) wafer.

The die will include the irregularly or broken surfaces and will include a plurality of other side surface that are smooth, scalloped, or otherwise more regular than the broken surface.

For example, during the method of manufacturing the semiconductor die, an array of active areas are formed on the substrate by forming a multilayer structure (which may include dielectric layers, insulating layers, conductive layers, passivation layers, repassivation layers, etc.) on a surface of the substrate.

A plurality of recesses are formed extending into the substrate around individual ones of the active areas to pre-formed cavities within the substrate.

A plurality of extension portions remain coupling the semiconductor dice to the substrate.

Each die overlaps and is suspended over a corresponding one of the pre-formed cavities.

The extension portions coupling the semiconductor dice and the substrate are broken to release the semiconductor dice from the substrate. This breaking forms the surfaces having a more irregular texture as compared to other side surfaces of the semiconductor dice.

The extension portions may be broken by utilizing a pick and place machine to pick up the semiconductor dice.

When forming a semiconductor die utilizing the disclosed method of manufacturing as discussed above, the semiconductor die may be made thinner than conventional semiconductor dice that are formed by utilizing a grinding process or other similar or suitable techniques. For example, these conventional semiconductor dice have an overall thickness ranging from 50 to 800 µm, whereas the semiconductor die formed utilizing the described method as discussed above has an overall thickness in the range of 10-30- µm.

The thickness may be substantially equal to or less than 10 µm.In other words, the semiconductor die formed utilizing the above embodiment of the method of manufacturing the present disclosure reduces the overall thickness of the semiconductor die as compared to conventional semiconductor die. This reduces the overall footprint and profile of the semiconductor die. This reduced space allows for a greater number of die to be positioned within the electronic device to perform ever increasingly complex functions. This allows for the electronic device to be thinner as compared to conventional die in electronic devices.

The shape and size of the semiconductor die may be selected when forming the active area. For example, the active areas may be formed to have an irregular shape or profile (*e.g*., an N-gon polygon such as an oval, a pentagon, a hexagon, or some other irregular shape) as compared to conventional die that are generally rectangular or square shapes. The recesses can be precisely to have the irregular shape or profile of the active area. The customizable adjustability of the present method of manufacturing allows for the semiconductor die to have a shape not possible with conventional die.

The overall cost and lead-time of manufacturing the semiconductor die is less than manufacturing a conventional die in which a grinding process is generally utilized to thin a substrate. Forming the die of the present disclosure generally does not include a grinding process or a traditional singulation process (*e*.*g*., grinding, sawing, lasering, back grinding, etc.). This reduces the number of machines to be utilized throughout various steps of the method of manufacturing. For example, the semiconductor die may be transferred between machines fewer times relative to manufacturing of a conventional semiconductor die.

For example, in a conventional method of manufacturing a semiconductor die, a back grinding process is performed to reduce a thickness of a substrate. Then after the grinding process is performed the substrate is singulated or diced into individual conventional semiconductor die. However, unlike this conventional method, in at least some of the embodiments of the methods of manufacturing the semiconductor die of the present disclosure, the extension portions are quasi-release structures that break when a pick-and-place machine picks up the semiconductor die breaking the semiconductor die away from a wafer.

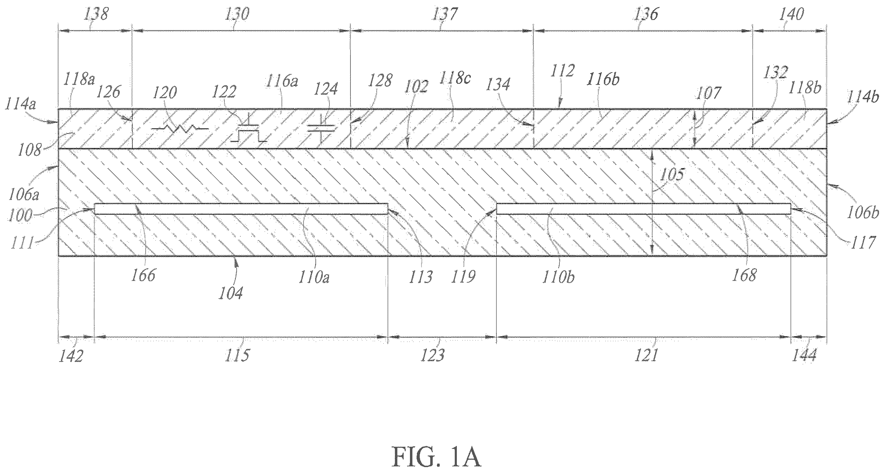

Figures 1A-1D are directed to a method of manufacturing of a semiconductor device package as shown in Figures IE and IF.

Figure 1A is a side cross-section showing forming a multilayer structure 108 on a first surface 102 of a substrate 100, which may be a wafer. For example, when the substrate 100 is the wafer, the wafer may be a circular wafer that includes a number of areas at which a number of dice are to be formed at the surface of the wafer. The substrate 100 may be a silicon material. The multilayer structure (described in more detail below) may form active and passive circuitry or micro-electromechanical components.

The substrate 100 further includes a second surface 104 opposite to the first surface 102, and a plurality of sidewalls 106a, 106b extending from the first surface 102 to the second surface 104. A first sidewall 106a is on the left-hand side of the substrate 100, and a second sidewall 106b is on the right-hand side of the substrate 100 based on the orientation in Figure 1A. The substrate 100 has a thickness 105 that extends from the first surface 102 to the second surface 104 of the substrate 100.

A plurality of cavities or openings 110a, 110b are present within the substrate 100 at locations between the first surface 102 and the second surface 104 as well as the first sidewall 106a and the second sidewall 106b. A first cavity 110a includes a first end 111 and a second end 113 opposite to the first end 111. The first end 111 is closer to the first sidewall 106a of the substrate 100 and the second end 113 is closer to the second sidewall 106b of the substrate 100. The first cavity 110a has a dimension 115 extending from the first end 111 to the second end 113. The dimension 115 will be greater than a dimension 130 that is associated with an active area of a respective die, aligned with the cavity.

When the substrate 100 is the wafer, the plurality of cavities 110a, 110b are ones of an array of cavities or openings within the wafer that are aligned with corresponding ones of ones of semiconductor die to be formed utilizing the wafer. The wafer with these cavities or openings may be referred to as a silicon-on-nothing (SON) wafer or substrate.

A second cavity 110b includes a third end 117 and a fourth end 119 opposite to the third end 117. The third end 117 is closer to the second sidewall 106b of the substrate 100 and the fourth end 119 is closer to the first sidewall 106a.

The second cavity 110b has a dimension 121 extending from the third end 117 to the fourth end 119. In Figure 1A, the dimension 115 of the first cavity 110a and the dimension 121 of the second cavity 110b are substantially equal to each other. In alternative embodiments, the dimensions 115, 121 of the first and second cavities 110a, 110b may be different from each other.

The second end 113 of the first cavity 110a is spaced apart from the fourth end 119 of the second cavity 110b by a dimension 123. In Figure 1A, the dimension 123 is less than the dimensions 115, 121 of the first and second cavities 110a, 110b.

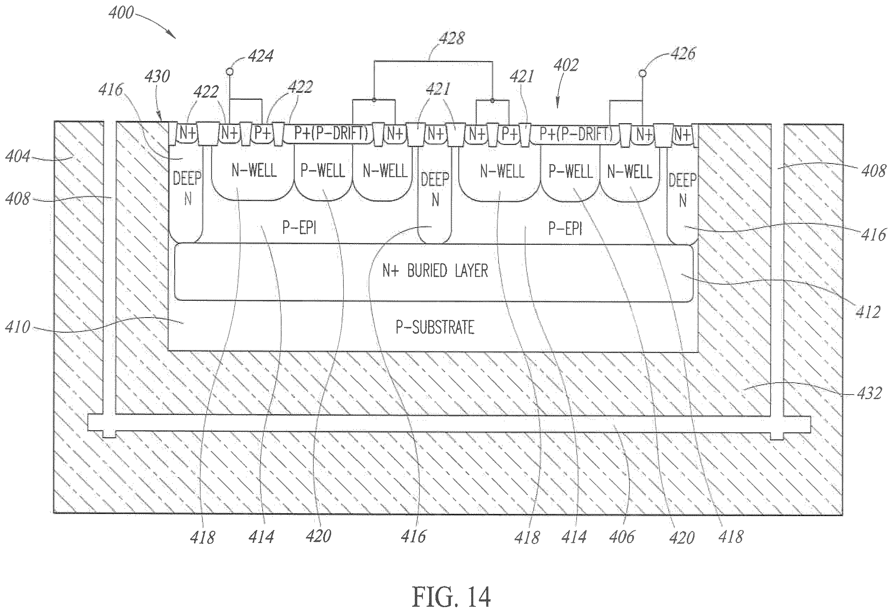

While not shown, the substrate 100 may further include first doped regions and second doped regions that are present at the first surface 102 that interact with components of the multilayer structure. The first and second doped regions may extend into the substrate 100 at the first surface 102 of the substrate 100. For example, the first doped regions may be p-type doped regions and the second doped regions may be n-type doped regions. See Figure 14.

While not shown, in some embodiments, the substrate 100 may further include a plurality of contact pads coupled to a plurality of electrical connections extending through the substrate 100. The plurality of electrical connections may include a plurality of conductive layers, a plurality of through silicon vias (TSVs), or some other type of electrical connection or combination of electrical connections or pathways. The cavities 110a, 110b may be pre-formed cavities 110a, 110b within the substrate 100 that were formed in the substrate 100 before the multilayer structure 108 is formed on the first surface 102 of the substrate 100.

Forming the multilayer structure 108 on the first surface 102 of the substrate 100 includes forming a plurality of conductive and dielectric layers to form passive and active structures, like transistors, diodes, resistors, and capacitors arranged to perform a selected circuit function.

For example, a vapor deposition process is performed forming an oxide layer (*e.g*., silicon dioxide SiO₂) on and covering the first surface 102 of the substrate 100. A photoresist layer is formed on the oxide layer to cover a surface of the oxide layer. A mask layer is formed and patterned on the photoresist layer exposing selected areas of the photoresist layer. An etching process is performed to etch the oxide layer. This etching step patterns the oxide layer and exposes selected areas of the first surface 102 of the substrate 100. After the oxide layer is patterned, a stripping process is performed in which the photoresist layer and the mask layer are exposed to chemicals to remove the photoresist layer and the mask layer.

A sputtering process may be performed forming a conductive layer on the oxide layer. In this case, the conductive layer covers the oxide layer and covers the selected areas of the substrate 100 that were exposed from the oxide layer. The conductive layer may be a copper material, a silver material, a gold material, or some other type of conductive material. A polishing or grinding process is performed removing first portions of the conductive layer on the oxide layer and leaving second portions of the conductive layer on the first surface 102 of the substrate 100, in the oxide layer, and at the selected areas of the first surface 102.

After forming the conductive portion, the above steps may be then performed in a similar manner and order to continue forming any number of conductive portions to form any number of various electrical components on the first surface 102 of the substrate 100.

The multilayer structure 108 may include a redistribution layer (RDL). The multilayer structure 108 includes a third surface 112 that faces away from substrate 100, and a plurality of sidewalls 114a, 114b that extend from the first surface 102 of the substrate 100 to the third surface 112 of the multilayer structure 108. The third sidewall 114a is substantially coplanar with the first sidewall 106a, and the fourth sidewall 114b is substantially coplanar with the second sidewall 106b. The multilayer structure 108 includes a thickness 107 extending from the first surface 102 of the substrate 100 to the third surface 112 of the multilayer structure 108. The thickness 107 of the multilayer structure 108 is less than the thickness 105 of the substrate 100.

The multilayer structure 108 includes active areas 116a, 116b and a first scribe area 118a, a second scribe area 118b, and a third scribe area 118c. The active areas 116a, 116b are spaced apart from each other by the scribe areas 118a, 118b, 118c.

The active areas 116a, 116b are present in a completed semiconductor die 184 in Figures IE and IF. The active areas 116a, 116b may include resistors 120, transistors 122, capacitors 124, or other combinations of active and passive components.

The first active area 116a includes a first end 126 and a second end 128 opposite to the first end 126. The first end 126 is directly adjacent to the first scribe area 118a and the second end 128 is directly adjacent to the third scribe area 118c. The first end 126 may abut the first scribe area 118a and the second end 128 may abut the third scribe area 118c. The first active area 116a has a dimension 130 that extends from the first end 126 to the second end 128. The dimension 130 is less than the dimension 115 of the first cavity 110a.

The second active area 116b includes a third end 132 and a fourth end 134 opposite to the third end 132. The third end 132 is directly adjacent to the second scribe area 118b and the fourth end 134 is directly adjacent to the third scribe area 118c. The third end 132 may abut the second scribe area 118b and the fourth end 134 may abut the third scribe area 118c. The second active area 116b has a dimension 136 that extends from the third end 132 to the fourth end 134. The dimension 136 is less than the dimension 121 of the second cavity 110b. Here, the dimension 136 of the second cavity 110b is substantially equal to the dimension 130 of the first cavity 110a. In the alternative, the dimension 130 may be greater than the dimension 136 or vice versa.

The second end 128 of the first active area 116a is spaced apart from the fourth end 134 of the second active area 116b by a dimension 137. The dimension 137 is greater than the dimension 123 between the second end 113 of the first cavity 110a and the fourth end 119 of the second cavity 110b.

The third scribe area 118c is between the second end 128 of the first active area 116a and the fourth end 134 of the second active area 116b. The first and second scribe areas 118a, 118b are at peripheral regions of the first surface 102 of the substrate 100, and the third scribe area 118c is at a central region of the first surface 102 of the substrate 100. The scribe areas 118a, 118b, 118c may be kerf areas, frame areas, or some other type of sacrificial areas that do not include layers or electrical components to be present in the completed semiconductor die 184.

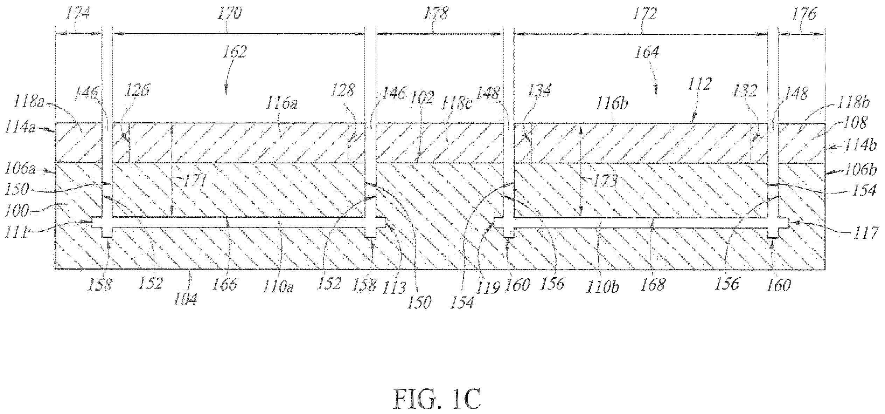

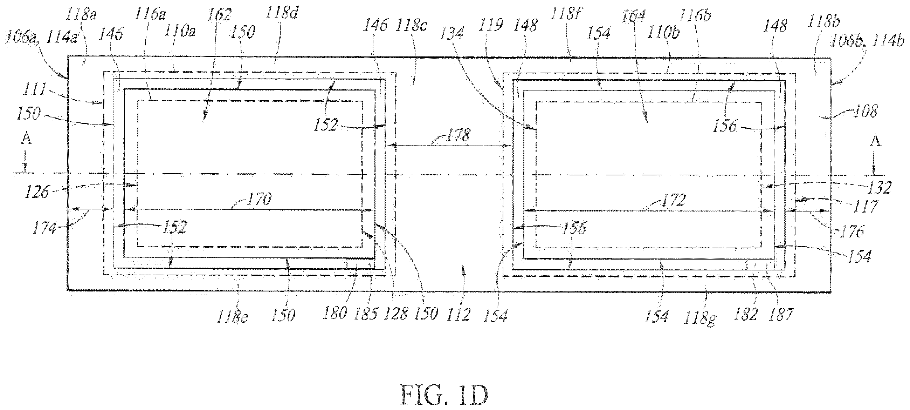

The recesses 146, 148 as shown in Figures 1C and 1D may be formed extending into the multilayer structure 108 and into the substrate 100 to the cavities 110a, 110b within the substrate 100.

The first scribe area 118a has a dimension 138 that extends from the first end 126 of the first active area 116a to the third sidewall 114a of the multilayer structure 108. The second scribe area 118b includes a dimension 140 that extends from the third end 132 of the second active area 116b to the fourth sidewall 114b of the multilayer structure 108. The third scribe area 118c has the dimension 137.

The dimension 138 of the first scribe area 118a and the dimension 140 of the second scribe area 118b are here substantially equal to each other. However, the dimensions 138, 140 may be different from each other.

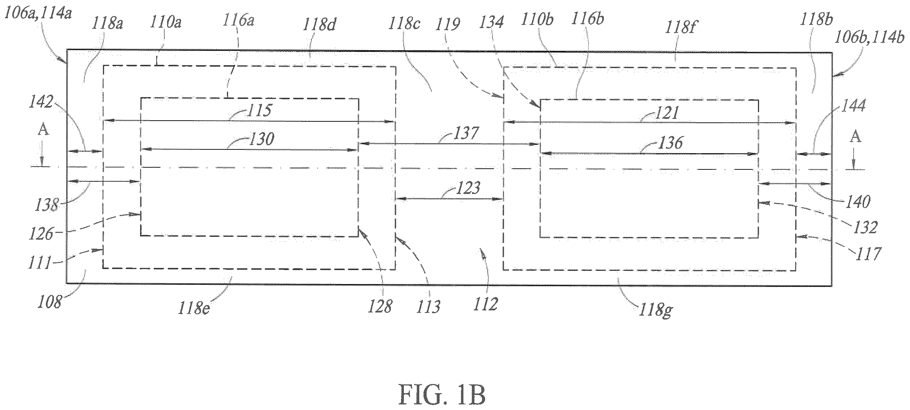

Figure 1B is a top plan view of the first active area 116a and the second active area 116b.

The first active area 116a and the second active area 116b may be substantially the same size and shape (e.g., rectangular) relative to each other. However, the first active area 116a may be a different size and shape relative to the second active area 116b or vice versa. For example, the first active area 116a may be substantially rectangular in shape when viewed in the top plan as shown in Figure 1B and the second active area 116b may be substantially hexagonal in shape when view in the top plan view in Figure 1B.

The multilayer structure 108 further includes a fourth, a fifth, a sixth, and a seventh scribe area 118d, 118e, 118f, 118g. The scribe areas 118a, 118b, 118c, 118d, 118e, 118f, 118g are continuous with each other and surround the first and second active areas 116a, 116b. For example, the first, third, fourth, and fifth scribe areas 118a, 118c, 118d, 118e surround the first active area 116a and form a frame or boundary around the first active area 116a, and the second, third, sixth, and seventh scribe areas 118b, 118c, 118f, 118g surround the second active area 116b and form a frame or boundary around the second active area 116b.

The dotted line representative of the first cavity 110a within the substrate 100 surrounds the dotted line representative of the first active area 116a in the multilayer structure 108. The dotted line representative of the second cavity 110b within the substrate 100 surrounds the dotted line representative of the second active area 116b in the multilayer structure 108.

The first end 111 is spaced apart from the first sidewall 106a of the substrate 100 by a dimension 142 as shown in Figure 1A. The third end 117 is spaced apart from the second sidewall 106b of the substrate 100 by a dimension 144 as shown in Figure 1A. The dimension 142 is less than the dimension 138, and the dimension 144 is less than the dimension 140.

The dimension 142 being less than the dimension 138 and the dimension 144 being less than the dimension 140 provides clearance for the recesses 146, 148 to be formed at locations that extend between the dotted line representing the active areas 116a, 116b and the dotted lines representing the cavities 110a, 110b as shown in Figure 1B. The recess on the left-hand side of Figure 1C and 1D partially surrounds the first active area 116a and is a first recess 146, and the recess on the right-hand side of Figures 1C and 1D partially surrounds the second active area 116b and is a second recess 148.

In Figure 1C, the recesses 146, 148 are formed. The recesses 146, 148 extend into the third surface 112 of the multilayer structure 108 at least to a corresponding one of the cavities 110a, 110b. The recesses 146, 148 may be formed by a drilling technique, a laser drilling technique, an etching technique, a patterning technique, or some other type of recess formation technique.

By way of example, when an etching technique is utilized to form the recesses 146, 148, the etching technique may be a deep etching technique (*e*.*g*., deep reactive ion etching (DIRE) process or deep silicon etching technique. In this case, a mask layer (not shown) is applied to the third surface 112 of the multilayer structure 108. The mask layer protects the first and second active areas 116a, 116b from being etched when forming the recesses 146, 148. The mask layer is patterned such that the mask layer leaves areas of the third surface 112 exposed at locations at which the recesses 146, 148 are to be formed.

The mask layer may be patterned by an additional step in which selected portions of the mask layer are exposed to a chemical to expose the areas of the third surface 112 at which the recesses 146, 148 are to be formed. In the alternative, the mask layer may instead have been applied to the third surface 112 of the multilayer structure 108 without covering the areas of the third surface 112 at which the recesses 146, 148 are to be formed. For example, the mask layer may be formed utilizing a stencil lithography technique to selectively apply the mask layer while leaving areas of the third surface 112 corresponding to locations at which the recesses 146, 148 are to be formed.

When the deep etching process is utilized to form the recesses 146, 148, a first etching step, which is an isotropic etching step, is performed forming a first recess portion of the first recess 146 extending into the third surface 112. After the first recess portion is formed, a first passivation layer is formed on the mask layer and in the first recess portion covering sidewalls of the first recess portion and end surfaces of the first recess portion. The end surfaces are the surfaces at which the first recess portions terminate within the multilayer structure 108.

After the first passivation layer is formed, a second etching step, which is an anisotropic etching step, is performed deteriorating (*e*.*g*., dissolving) a portion of the first passivation layer present on the end surface of the first recess portion exposing the end surface from the first passivation layer. The second etching step does not deteriorate portions of the passivation layer present on the sidewalls of the first recess portion. In other words, after the second etching step is performed, the portions of the passivation layer initially on the sidewalls of the first recess portion are still present at and covering the sidewalls of the first recess portion.

After the second etching step is performed, a third etching step is performed, which is an anisotropic etching, forming a second recess portion extending into the multilayer structure 108 by deteriorating the multilayer structure 108 exposed at the end surface of the first recess portion that was previously exposed from the first passivation layer by the second etching step. The second recess portion is in fluid communication with the first recess portion and is further within the multilayer structure 108 than the first recess portion. In other words, the first recess portion is stacked on the second recess portion.

After the third etching step, a second passivation layer may be formed covering sidewalls of the second recess portion and an end surface of the second recess portion, which are similar to the sidewalls and the end surface of the first recess portion. After the second passivation layer is formed, a fourth etching step is performed, which is an isotropic etching step, to deteriorate a portion of the second passivation layer exposing the end surface of the second recess portion from the second passivation layer. After the end surface of the second recess is exposed from the second passivation layer, a fifth etching step is performed, which is an anisotropic etching step, forming a third recess portion extending into the multilayer structure 108 by deteriorating the multilayer structure 108 exposed at the end surface of the second recess portion.

These steps of the deep etching process may be then successively performed over and over again until the first recess 146 is formed extending into the third surface 112 of the multilayer structure 108 to the first cavity 110a. The above process for forming the first recess 146 may readily apply to forming the second recess 148 as well, and the second recess 148 may be formed substantially at the same time or simultaneously with the first recess 146.

When utilizing the deep etching technique to form the recesses 146, 148, respective inner sidewalls 150, 154 and respective outer sidewalls 152, 156 of the recesses 146, 148 are scalloped such that the respective inner sidewalls 150, 154 and the respective outer sidewalls 152, 156 are scalloped surfaces. The inner and outer sidewalls 150, 154 include sidewalls of the multilayer structure 108 and the substrate 100 that are spaced inwardly from the sidewalls 106a, 106b, 114a, 114b of the multilayer structure 108 and the substrate 100. Each of the scallops of these scalloped surfaces are relatively the same size as each other when the deep etching technique is utilized to form the recesses 146, 148 as shown in Figures 1C and 1D.

First inner sidewalls 150 of the first recess 146 are closer to the first active area 116a than first outer sidewalls 152 of the first recess 146. Second inner sidewalls 154 of the second recess 148 are closer to the second active area 116b than second outer sidewalls 156 of the second recess 148.

The first recess 146 is positioned between the respective ends 126, 128 of the first active area 116a and the respective ends 111, 113 of the first cavity 110a. For example, a left-most portion of the first recess 146 based on the orientation as shown in Figure 1C is between the first end 111 of the first cavity 110a and the first end 126 of the first active area 116a. Whereas a right-most portion of the first recess 146 based on the orientation as shown in Figure 1C is between the second end 113 of the first cavity 110a and the second end 128 of the first active area 116a. In other words, the first recess 146 is spaced inwardly from the first end 111 and the second end 113 of the first cavity 110a, and the first recess 146 is spaced outwardly from the first active area 116a.

The first recess 146 includes a first termination end 158 that extends past the first cavity 110a such that first termination end 158 is closer to the second surface 104 of the substrate 100 than the first cavity 110a. In the alternative, the first recess 146 may not have the first termination end 158, and, instead, the first recess 146 may only extend to the first cavity 110a and not extend past the first cavity 110a. The first recess 146 is in fluid communication with the first cavity 110a.

The second recess 148 is positioned between the respective ends 134, 132 of the second active area 116b and the respective ends 117, 119 of the second cavity 110b. The second recess 148 is spaced inwardly from the third end 117 and the fourth end 119 of the second cavity 110b, and the second recess 148 is spaced outwardly from the second active area 116b.

The second recess 148 includes a second termination end 160 that extends past the second cavity 110b such that the second termination end 160 is closer to the second surface 104 of the substrate 100 than the first cavity 110a.

The first and second recesses 146, 148 are formed to be spaced outwardly from the first and second active areas 116a, 116b, respectively. The first recess and second recesses are formed in the scribe areas surrounding the first and second active areas.

Forming the recesses 146, 148 extending into the multilayer structure 108 and the substrate 100 to the cavities 110a, 110b forms a first die structure 162 and a second die structure 164 suspended above the first and second cavities 110a, 110b, respectively by extension portions not visible in this view. Forming the first recess 146 defines a first lower surface 166 of the first die structure 162 based on the orientation as shown in Figure 1C. The first lower surface 166 is spaced apart from the substrate 100 by the first cavity 110a, and the first lower surface 166 was at least part of a surface initially defining the first cavity 110a. Forming the second recess 148 defines a second lower surface 168 of the second die structure 164 based on the orientation as shown in Figure 1C. The first inner sidewalls 150 of the first recess 146 are sidewalls of the first die structure 162. The second inner sidewalls 154 of the second recess 148 are sidewalls of the second die structure 164.

The first and second lower surfaces 166, 168 may be passive surfaces of the first and second die structures 162, 164. Portions of the third surface 112 of the first and second die structures 162, 164 may be active surfaces of the first and second die structures 162, 164.

The first die structure 162 includes a dimension 170 extending from opposite ones of the first inner sidewalls 150. The dimension 170 is less than the dimension 115 of the first cavity 110a and is greater than the dimension 130 of the first active area 116a as shown in Figure 1A.

The second die structure 164 includes a dimension 172 extending from opposite ones of the second inner sidewalls 154. The dimension 172 is less than the dimension 121 of the second cavity 110b and is greater than the dimension 136 of the second active area 116b as shown in Figure 1A.

The first die structure 162 includes a first thickness 171 that extends from the first lower surface 166 to the third surface 112 of the multilayer structure 108. The second die structure 164 includes a second thickness 173 that extends from the second lower surface 168 to the third surface 112 of the multilayer structure 108. In this embodiment, the first thickness and the second thickness are substantially equal to each other. In the alternative, the first thickness and the second thickness may be substantially different from each other when the first die structure 162 and the second die structure 164 are formed to have different structures relative to each other. For example, the first cavity 110a may be at a first depth further from the first surface 102 of the substrate 100, and the second cavity 110b may be at a second depth from first surface 102 of the substrate 100. In other words, the first cavity 110a may be further away from the first surface 102 and closer to the second surface 104 as compared to the second cavity 110b such that one die utilizing the first cavity 110a is thicker than another die utilizing the second cavity 110b.

The first outer sidewall 152 of the first recess 146 at the left-hand side of Figure 1C is spaced apart from the sidewalls of the multilayer structure 108 and the substrate 100 on the left-hand side of Figure 1C by a dimension 174. Here, the dimension 174 is less than the dimension 138 as shown in Figure 1A.

The second outer sidewall 156 of the second recess 148 at the right-hand side of Figure 1C is spaced apart from the sidewalls of the multilayer structure 108 and the substrate 100 on the right-hand side of Figure 1C by a dimension 176. Here, the dimension 176 is less than the dimension 140 as shown in Figure 1A.

The right-most outer sidewall 152 of the first recess 146 based on the orientation as shown in Figure 1C and the left-most outer sidewall 156 of the second recess 148 based on the orientation as shown in Figure 1C are spaced apart from each other by a dimension 178. The dimension 178 is less than the dimension 137 between the first and second active areas 116a, 116b as shown in Figure 1A.

Figure 1D is a top plan view after forming the recesses 146, 148. The first recess 146 is a continuous recess that surrounds the majority of the first active area 116a, and the second recess 148 is a continuous recess that surrounds the majority of the second active area 116b. The first recess 146 forms a boundary and separates a majority of the first die structure 162 from the substrate 100.

A first extension 180 is formed when forming the first recess 146 such that first extension 180 couples the first die structure 162 to the substrate 100 and holds the first die structure 162 above the first cavity 110a as shown in Figure 1C. The first die structure 162 is coupled to the substrate 100 by the first extension 180, which laterally extends from the substrate 100 to the first die structure 162. In Figure 1D, the first extension 180 is located at the lower right-hand corner of the first die structure 162. However, the first extension 180 may be positioned at a different location or at a plurality of locations.

A second extension 182 is formed like the first extension 180 and couples the second die structure 164 to the substrate 100 such that the second extension 182 holds the second die structure 164 above the second cavity 110b. The second extension 182 laterally extends from the substrate 100 to the second die structure 164.

The first and second extensions 180, 182 include non-essential portions of the substrate 100 and the multilayer structure 108. The first inner and outer sidewalls 150, 152 at the bottom of the first die structure 162 are smaller or shorter than a dimension of the first inner and outer sidewalls 150, 152 at the top of the first die structure 162 in a first direction, left to right in Figure 1D. The first and second extensions 180, 182 may be referred to as extension portions, extension structures, or some other type of structures coupling the first and second die structures 162, 164 to the substrate 100.

The first and second extensions 180, 182 are release or quasi-release structures that are to be broken to release the first die structure 162 and the second die structure 164 from the substrate 100. The recesses 146, 148 are formed at a front-end of this method of manufacturing instead of at a back-end as is typical of conventional processing techniques.

The first and second extensions 180, 182 are extension of the substrate 100. A recess 185 is aligned with the first extension 180 and a recess 187 is aligned with the second extension 182. The recesses 185, 187 are formed extending through the multilayer structure 116 to the first surface 102 of the substrate 100 exposing surfaces of the first and second extensions 180, 182. Here, the recesses 185, 187 have a depth substantially equal to the thickness 107. In the alternative, the recesses 185, 187 may not be present such that the first and second extension 180, 182 include portions of the multilayer structure as well.

Figures IE and IF show a first die 184 formed by releasing (e.g., breaking away) the first die structure 162 or the second die structure 164. The first die 184 may be referred to an ultra-thin semiconductor die or an ultra-thin completed semiconductor die. For example, the first thickness 171 of the ultra-thin semiconductor die 184 is in the range from 10-30 µm. However, the thickness 171 of the ultra-thin semiconductor die 184 may be substantially equal to or less than 10 µm.

The second thickness 173 may be in the range 10-30 µm.However, the second thickness 173 may be substantially equal to or less than 10µm.

The following discussion is directed to the first die 184 formed by breaking away the first die structure 162 from the substrate 100. A pick-and-place machine picks up the first die structure 162 when the first die structure 162 is still coupled to the substrate 100, breaking the first extension 180. When picking up the first die structure 162, the pick-and-place machine may pull on the first die structure 162 applying enough force to the first extension 180 such that a crack begins to propagate along or within the first extension 180. As the pick-and-place machine applies further force to the first die structure 162, the first extension 180 eventually completely cracks (e.g., breaks) causing the first die structure 162 to be released from the substrate 100 forming the first die 184. The pick-and-place machine may pick up the first die structure 162 and the second die structure 164 at the same time such that the first die structure 162 and the second die structure 164 are released substantially at the same time.

The sidewall at the bottom of the first die 184 based on the orientation as shown in Figure 1B includes a uniform surface 186 and an irregular surface 188, the irregular surface 188 having a more irregular texture relative to the uniform surface 186 of the first die 184 adjacent to the textured surface. The uniform surface 186 may be scalloped similar to the inner and outer sidewalls 150, 152. The uniform surface 186 is more smooth and has a more consistent pattern of the features than the irregular surface 188. The irregular surface has a random pattern that is substantially not uniform as the irregular surface 188 is a result of breaking the first extension 180. The irregular surface 188 has a first surface area and the uniform surface 186 has a second surface area that is greater than the first surface area.

The random nature of the irregular surface 188 generally results in the irregular surface 188 having high points, low points, jagged regions, smooth regions, or any other irregular texture along the irregular surface 188. For example, as shown in Figure IE, the irregular surface 188 has a jagged appearance with several mountain like shapes extending away from the first active area 116a and away from the sidewall at the bottom of the first die 184. The jagged or outer most points of the irregular surface are spaced further from the active area than the surface 186.

Here, the irregular surface 188 is along the substrate 100, which is a silicon material such that the irregular surface 188 is a silicon material as well. In the alternative, the irregular surface 188 may extend along a sidewall of the multilayer structure as well such that the irregular surface 188 extends from the first lower surface 166 to the third surface 112 (upper surface() and includes portions of both the multilayer structure 116 and the substrate 100. The irregular surface 188 may be a non-conductive surface or may be a semiconductor surface.

The first die 184 further includes a non-active area or inactive portion 190 that surrounds the first active area 116a. The non-active area 190 forms a boundary around the first active area 116a. The non-active area 190 is formed during the processing steps to form the active area, i.e. the kerf area, which is cut when the first recess 146 is formed. The non-active area 190 has a dimension 192 that extends from the first end 126 of first active area 116a to the sidewall at the left-hand side of Figure IE. The dimension 192 is less than the dimension of the associated kerf region.

The dimension 192 of the non-active area 190 may be substantially the same as one moves around the first active area 116a except for at the irregular surface 188. For example, the irregular surface 188 includes high points and low points that are different distances away from a bottom edge of the first active area 116a. For example, high points of the irregular surface 188 may be spaced apart a distance greater than the dimension 192 from the bottom edge of the first active area 116a. However, the irregular surface 188 may have low points that extend further into the non-active region such that the low points are located somewhere between the bottom sidewall and the bottom edge of the first active area 116a.

In Figure IF, the first active area 116a, which was formed from the multilayer structure 108, is less thick than the substrate 100. The active area may be thicker than the remaining substrate 100.

The first die 184 may be a pressure senor, an optical sensor, a sound sensor, a light sensor, or some other type of sensor. The first die 184 may be an application-specific integrated circuit (ASIC) die, a controller die, an interconnection die, an integrated circuit die, or some other type of die. In other words, the first die 184 may be formed and customized to perform any function as requested by a customer.

The die 184 may only be partially completed after being broken away from the substrate 100. The die 184 may undergo further processing after being broken away from the substrate 100. For example, further layers of material (e.g., insulating, conductive, semiconductor, dielectric, etc.) may be formed on the die 184 to further refine and process the die 184 to complete the die 184.

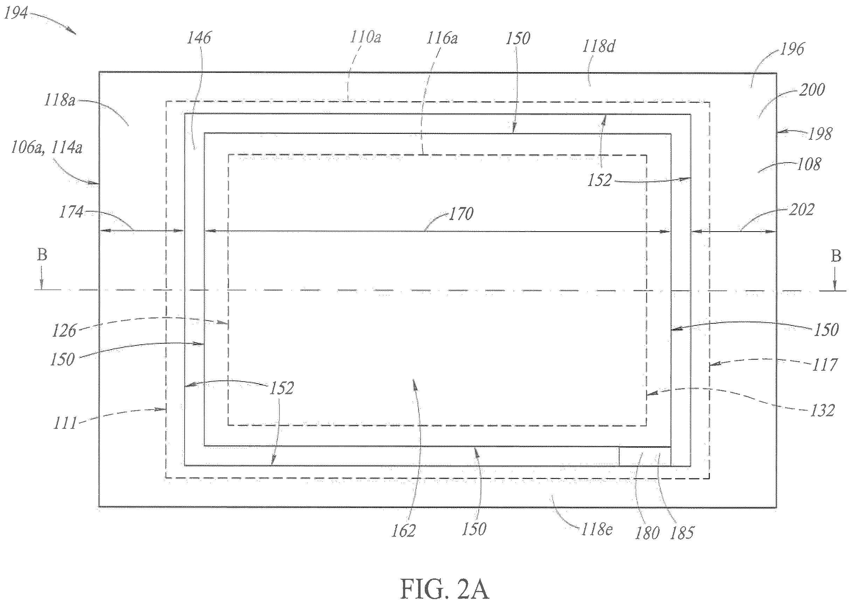

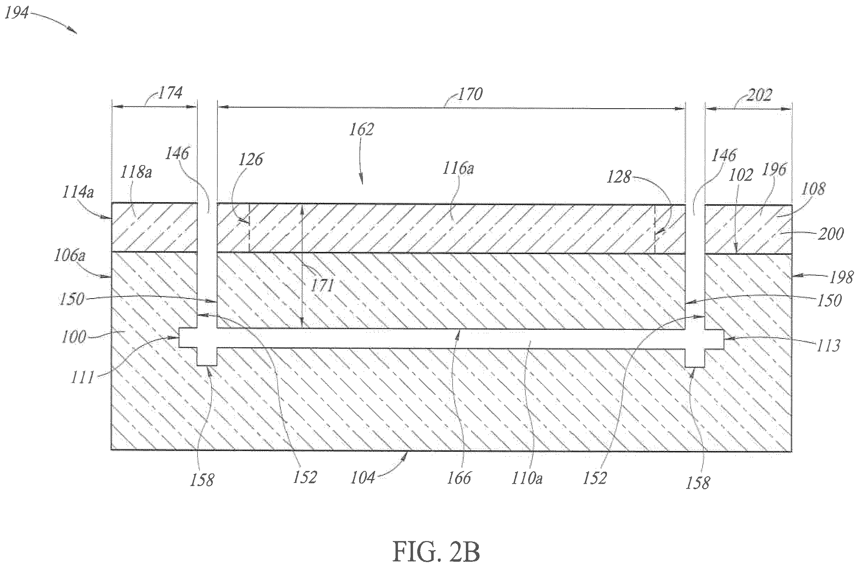

Figures 2A is a top plan view of a first die structure assembly 194 formed by an alternative method of manufacturing. Figure 2B is a cross-sectional view of the first die structure assembly 194 taken along lines B-B as shown in Figure 2A. The first die structure assembly 194 has some of the features of the first die structure 162 on the right-hand side of Figure 1D. Accordingly, the same features shared between the first die structure 162 and the first die structure assembly 194 have the same reference numerals, and at least additional features of the first die structure assembly 194 as compared to the first die structure 162 will be described in further detail herein.

The first die structure assembly 194 is formed by following the steps as shown and discussed with respect to Figures 1A-1D. However, unlike the method of manufacturing of the first die 184 as discussed with respect to Figures 1A-1F, in the method of manufacturing the first die structure assembly 194, the substrate 100 and the multilayer structure 108 are singulated along the third scribe area 118c after the recesses 146, 148 are formed. The singulation step may be carried out by a mechanical singulation, a chemical singulation, a laser singulation, or some other type of singulation technique. This singulation at the third scribe area 118c forms a suspension structure 196 that surrounds the first die structure 162.

This singulation step forms a sidewall 198 including respective sidewalls of the multilayer structure 108 and the substrate 100 that are coplanar and flush with each other at the sidewall 198 of the suspension structure 196. By way of example, if the first die structure assembly 194 is formed utilizing a mechanical singulation technique, the sidewall 198 may be a substantially flat surface (e.g., not scalloped or having an irregular texture). The sidewall 198 is opposite to the sidewalls 106a, 114a of the substrate 100 and the multilayer structure 108 at the left-hand side of the first die structure assembly 194 as shown in Figures 2A and 2B. The suspension structure 196 includes the sidewalls 106a, 114a of the substrate 100 and the multilayer structure 108 as shown in Figures 1A-1D.

The first die structure assembly 194 includes the suspension structure 196 that is coupled to the first die structure 162 by the first extension 180. The suspension structure 196 is spaced apart from the first die structure 162 by the first recess 146 except for where the extension extends from the first die structure 162 to the suspension structure 196. The first die structure 162, which may be a central structure, is surrounded by the suspension structure 196, which may be a peripheral structure.

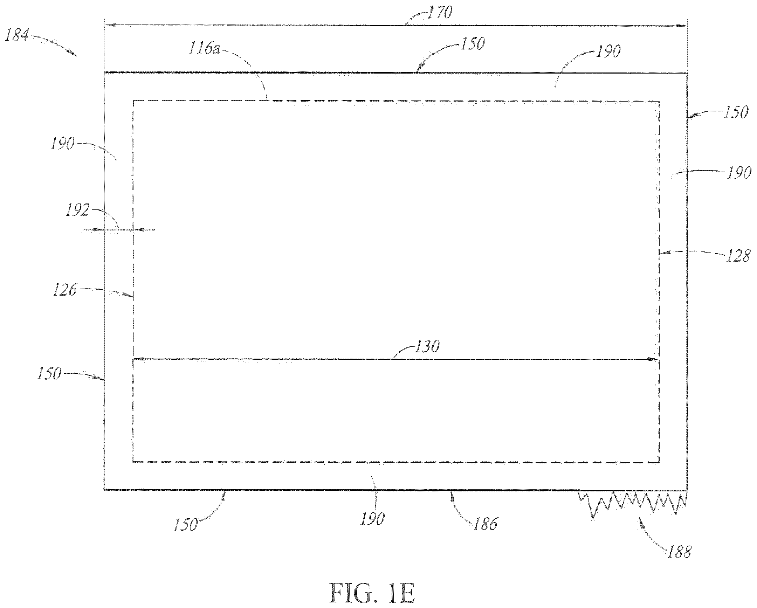

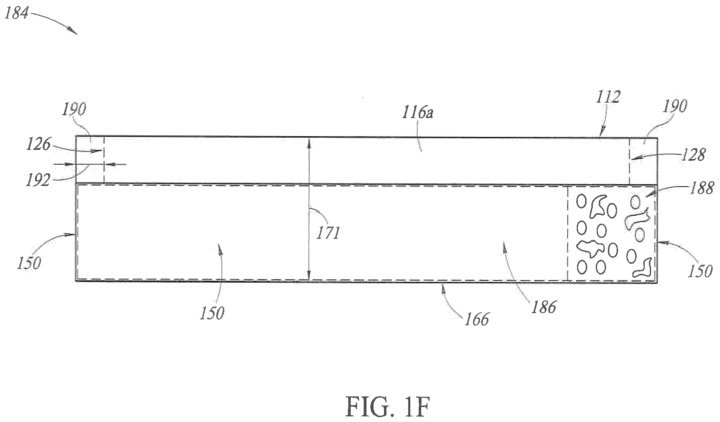

The suspension structure 196 includes a portion 200 that extends from the fourth scribe area 118d at the top of Figure 2A to the fifth scribe area 118e at the bottom of Figure 2A. The portion is a left-over portion of the third scribe area 118c after the singulation step has been carried out along the third scribe area 118c forming the first die structure assembly 194. The portion 200 has a dimension 202 that extends from the outer sidewall 152 of the first recess 146 at the right-hand side of Figure 2A to the sidewall at the right-hand side of Figure 2A. The dimension 202 is less than the dimension 137 as shown in Figures 1A and 1BHere, the dimension 202 is greater than the dimension 174. However, the dimension 202 may be substantially equal to or less than the dimension 174.

After the first die structure assembly 194 is formed, the first die structure assembly 194 may be shipped to a customer as is, and the customer may then release the first die structure 162 from the suspension structure 196 to form the first die 184 as shown in Figures IE and IF. In yet another situation, the customer may perform further processing before the first die structure 162 is released from the suspension structure 196.

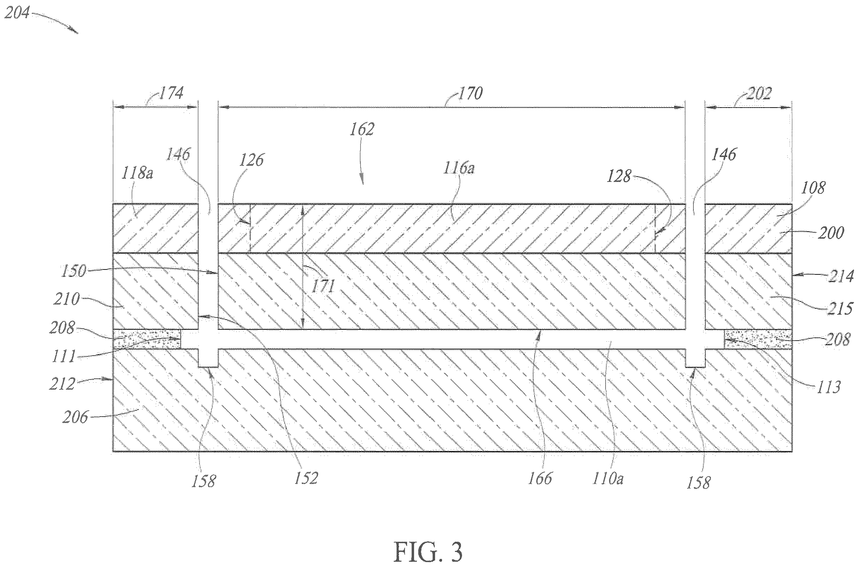

Figure 3 is directed to a second die structure assembly 204. The second die structure assembly 204 has some of the same features of the first die structure assembly 194 as shown in Figures 2A and 2B. Accordingly, the features shared between the first die structure assembly 194 and the second die structure assembly 204 have the same reference numerals, and at least additional features of the second die structure assembly 204 as compared to the first die structure assembly 194 will be described in further detail herein.

The second die structure assembly 204 is formed on a silicon on insulator wafer that includes a first substrate 206 stacked on a second substrate 210 with a dielectric 208 in between. The layer 208 may be an oxide material. The layer 208 surrounds the first cavity and is at the ends of the first cavity. The first cavity may have been pre-formed before forming the first die structure 162 or may be formed after the recesses are formed, i.e. the layer may be released after being exposed by the recesses. After the second substrate 210 is coupled to the first substrate 206 utilizing the layer 208, the recesses 146, 148 are formed and singulated in the same or similar manner as discussed with respect to Figures 1A-1D, 2A, and 2B. Here, the termination ends 158, 160 of the recesses 146, 148 extend into the second substrate 210. After the recesses 146, 148 are formed, the first substrate 206, the second substrate 210, and the multilayer structure 108 are singulated at the third scribe area 118c forming the second die structure assembly 204 as shown in Figure 3.

A first sidewall 212 is at the left-hand side of the second die structure assembly 204, and a second sidewall 214 is at the right-hand side of the second die structure assembly 204. The first and second sidewalls 212, 214 include respective sidewalls of the first substrate 206, the second substrate 210, the layer 208, and the multilayer structure 108 that are coplanar and flush with each other at the first and second sidewalls 212, 214.

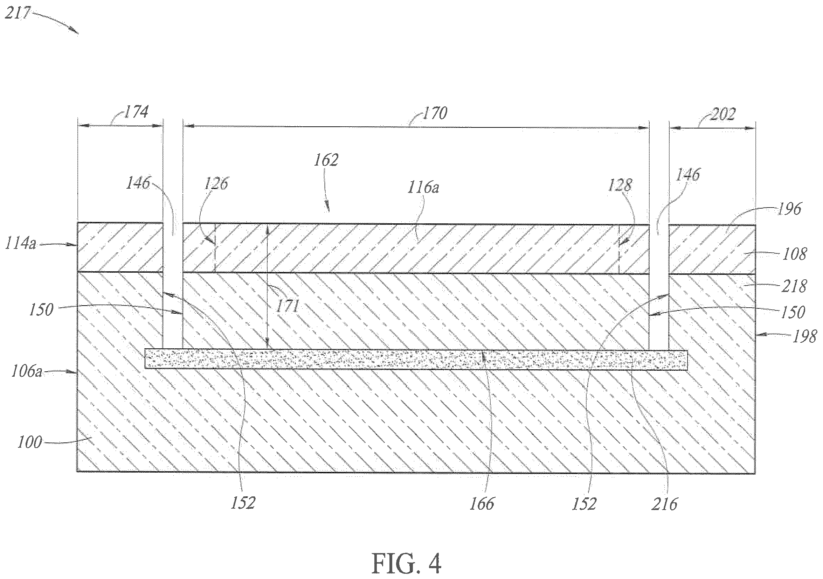

Figure 4 is directed to a third die structure assembly 217 that includes similar features to previous figures. The third die structure assembly includes a layer 216 positioned in the same or similar manner as the first cavity 110a as shown in Figures 2A, 2B, and 3. The third die structure assembly 217 includes a material in the cavity, such as the layer 216. The layer 216 may be pre-formed within the substrate 100 before forming the first die structure 162 such that the layer 216 is embedded within the substrate 100.

The first die structure 162 is on the layer 216 and is suspended above and separated from a suspension structure 218 by the layer 216, which may be an oxide layer or another suitable sacrificial material. The layer 216 also may replace the first extension 180 as shown in Figures 2A and 2B as the layer 216 suspends the first die structure 162 above the suspension structure 218. The first die structure 162 may be removed from the suspension structure 218 forming the first die 184 as shown in Figures IE and IF by dissolving the layer 216. The layer 216 may be dissolved by exposing the layer 216 to a chemical, which may be in gaseous or vapor form. After the layer 216 is dissolved, the first die structure 162 may be picked up by a pick and place machine to remove the first die structure 162 from within the suspension structure 218 forming the first die 184 as shown in Figures IE and IF.

Alternatively, the layer 216 may be utilized in combination with the first extension 180 as shown in Figures 2A and 2B. By way of example, the layer 216 is dissolved by exposing the layer 216 to the chemical, which may be in gaseous or vapor form. Then after the layer 216 is dissolved, the first die structure 162 is released from the suspension structure 218 by breaking the first extension 180 utilizing a pick and place machine in the same or similar manner as discussed earlier within the present disclosure with respect to Figures 1D-1F.

The recesses 146, 148 extend into the multilayer structure 108 and the substrate 100 and expose the layer 216 such that the chemical, which may be in gaseous or vapor form, is exposed to the layer 216 when dissolving the layer 216. However, unlike the first and second die structure assemblies, the first recess 146 does not include the first termination ends 158. The chemical partially deteriorates the layer 216 such that a portion of the layer 216 is still present between the lower surface 166 and the substrate 100. However, when a pick and place machine picks up the first die structure 162 to transfer the first die structure 162, the pick and place machine breaks the portion of the layer 216 still remaining between the first die structure 162 and the substrate 100. A portion of the layer 216 may still remain on the lower surface 166 such that an irregular surface of the layer 216 is on the lower surface 166 once the first die structure 162 has been removed from the substrate 100. Alternatively, the layer 216 may be fully deteriorated before a pick and place machine picks up the first die structure 162 to remove the first die structure 162 from the substrate 100.

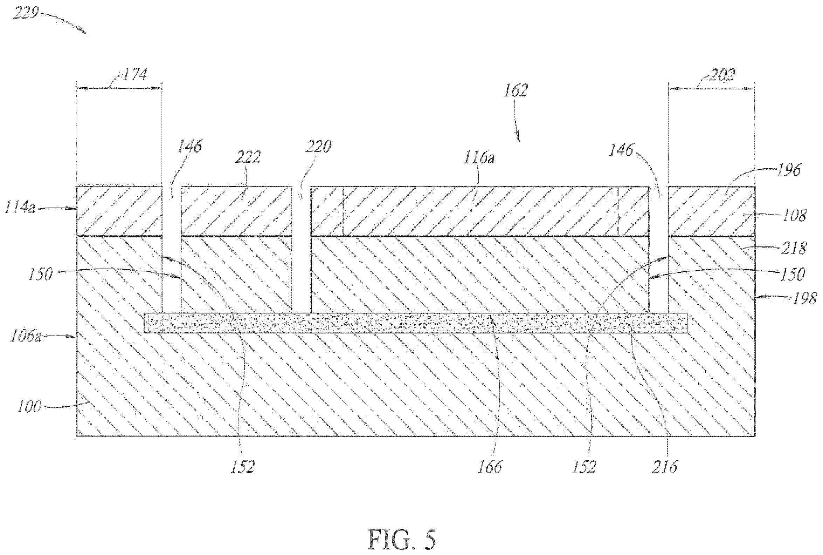

Figure 5 is directed to a fourth die structure assembly 229 of the present disclosure. The fourth die structure assembly 229 has some of the features of the first, second, and third die structure assemblies as shown in Figures 2A, 2B, 3, and 4. Accordingly, the features shared between the fourth die structure assembly 229 and the first, second, and third die structure assemblies have the same reference numerals, and at least additional features of the fourth die structure assembly 229 as compared to the first, second, and third die structure assemblies will be described in further detail herein.

The fourth die structure assembly 229 includes a third recess 220 between the right-side and the left-side of the first recess 146. The third recess 220 may be in fluid communication with the first recess 146. The third recess 220 extends into the multilayer structure 108 and the substrate 100 to the layer 216 and exposes the layer 216.

The fourth die structure assembly 229 includes a structure 222 formed from the multilayer structure 108 and the substrate 100. The structure 222 extends from the third recess 220 to the inner sidewall 150 of the first recess 146 at the left-hand side of Figure 5. The structure 222 may be an active structure that is electrically and physically coupled to the first die structure 162. For example, the structure 222 may be a light-receiving structure and the first die structure 162 may be a light-emitting (e.g., light-diode) structure such that the structure 222 and the first die structure 162 form a time-of-flight (TOF) sensor.

In the alternative, the structure 222 is a sacrificial structure to cause the first die structure 162 to have an irregular such as an n-gon shape (polygon with n sides) when viewed in the top plan view. For example, the first die structure 162 may have an L-shape, U-shape, or some other type of n-gon shape based on a pattern of the first recess 146 and the third recess 220.

A chemical is introduced through the first and third recesses 146, 220 to the layer 216 in the same or similar fashion as discussed earlier with respect to Figure 4. Accordingly, for simplicity and brevity of the present disclosure, the discussion of removing the first die structure 162 and the structure 222 will not be discussed in further detail herein.

The first die structure 162 is smaller in the fourth die structure assembly 229 as compared to the first, second, and third die structure assemblies as shown in Figures 2A, 2B, 3, and 4. For example, the first die structure 162 may have an overall volume less than the first die structures 162 as shown in Figures 2A, 2B, 3, and 4 in the other die assembly structures.

In view of the earlier discussion, it will be readily appreciated that instead of forming the die structure assemblies as shown in Figures 3, 4, and 5 utilizing a singulation step, completed semiconductor dice corresponding to the features of the die structures as shown in Figures 3, 4, and 5 may instead be broken away without singulating a substrate into the die structure assemblies as shown in Figures 3, 4, and 5. For example, the first die structure assembly 194 as shown in Figure 3 may be broken away after the recesses 146, 148 are formed to form a die similar to the die 184 as shown in Figures IE and IF.

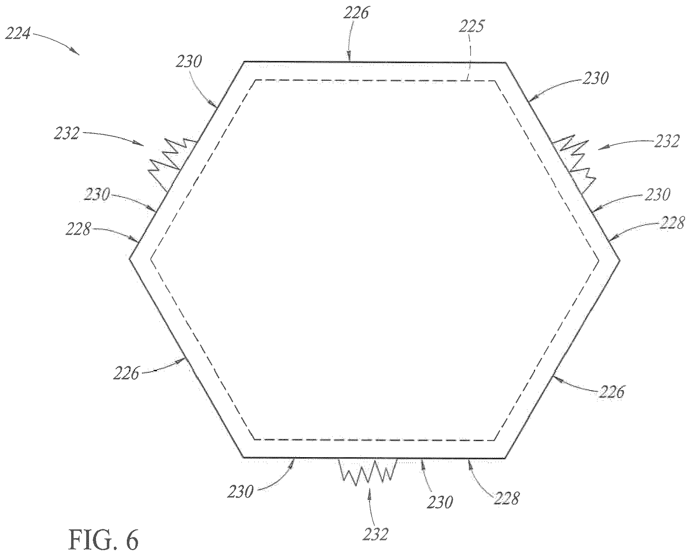

Figure 6 is a top-plan view of a second die 224 formed utilizing the method as discussed with respect to Figures 1A-1F. However, the second die 224 may be formed by forming the first recess 146 to have a substantially hexagonal shape, and the second die 224 may have an active area 225 that is substantially hexagonal in shape as well. Using the method of having a cavity buried in the substrate before forming an active area, including conductive and dielectric layer on a semiconductor, and releasing the die by etching down to the cavity provides an easy, front-end process of forming thin rectangular and non-rectangular die.

The second die 224 includes a plurality of first sidewalls 226 and a plurality of second sidewalls 228 such that the second die 224 has a non-rectangular or hexagonal shape. For example, adjacent ones of the plurality of first and second sidewalls 226, 228 are transverse to each other. Here, the adjacent ones of the plurality of first and second sidewalls 226, 228 are transverse to each other by an angle of 120°.

The first and second sidewalls 226, 228 have smooth or scalloped surfaces similar to the uniform surface 186 of the sidewall 150 as discussed earlier with respect to the first die 184. However, the second sidewalls 228 include a plurality of uniform surfaces 230 (*e.g*., scalloped surfaces) and a plurality of irregular surfaces 232. In the second die 224, each of the irregular surfaces 232 is between at least two corresponding uniform surfaces 230. The irregular surfaces 232 are centrally located on corresponding ones of the plurality of second sidewalls 228. In the alternative, the irregular surfaces 232 may not be centrally located along corresponding ones of the plurality of second sidewalls 228, and instead, the irregular surfaces 232 may be offset from centers of corresponding ones of the plurality of second sidewalls 228.

The irregular surfaces are formed by releasing the second die 224 from a substrate by breaking extensions coupling a die structure corresponding to the second die 224 to the substrate. Alternative embodiments of die may include rectangular shapes, triangular shapes, pentagon shapes, trapezoidal shapes, or some other n-gon shape.

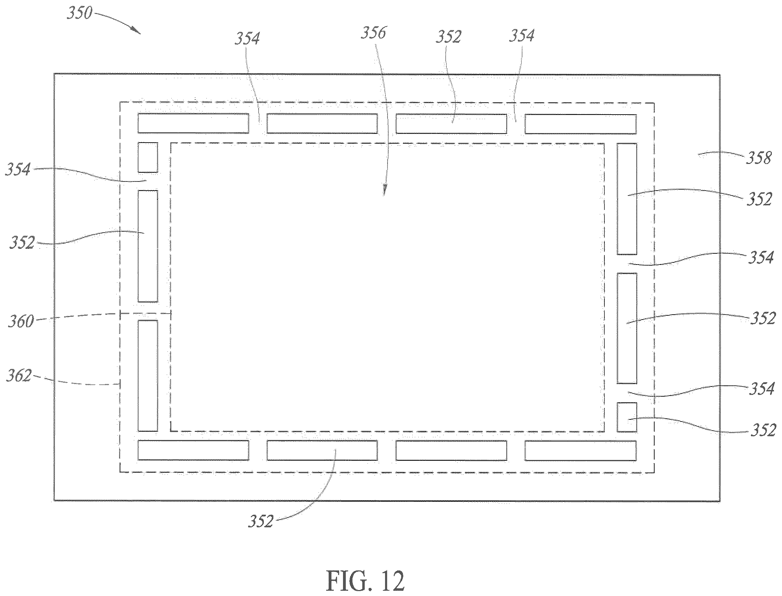

In a method of manufacturing the second die 224, a recess is formed extending into a substrate utilizing a deep silicon etching technique, which is the same or similar to the deep silicon etching technique as described earlier within the present disclosure. The recess may be one continuous recess having multiple hexagons abutting each other such that the recess has a honeycomb-like shape. In the alternative, a polygonal shape (e.g., rectangle, diamond, square, triangle, trapezoid, etc.) different than a hexagon may instead be utilized. In addition, the recess may be one continuous recess having multiple different polygonal shapes abutting each other *(e.g.,* a trapezoidal shape abutting a hexagonal shape) such that the recess forms die all having different polygonal shapes relative to each other *(e.g.,* one die have a hexagon shape and another die having a rectangular shape). The recess may be replaced with multiple recesses that are similar to perforations such as recesses 352 as shown in Figure 12.

Forming the recess defines die structures, a support structure, and extensions that couple the die structures to the support structure. The support structure extends from the substrate and suspends the die structures above pre-formed cavities within the substrate. The support structure may be an anchor structure, a column structure, a suspension structure, or some other type of structure that suspends the die structures over the substrate. A first respective extension extends laterally from the support structure to a first one of the die structures and a second respective extension extends laterally from the support structure to a second one of the die structures. The support structure may be positioned between the first one and second one of the die structures. The recess may surround the two die structures and the support structure such that the two die structures are suspended above the substrate.

The two die structures are then detached from the support structure by a pick and place machine that picks up the two die structures simultaneously breaking the two extensions substantially at the same time forming two die, which are both the same or similar to the second die 224 as shown in Figure 6. Having multiple die coupled to a single support structure allows for multiple die to be removed from the substrate in a single pick and place transfer step utilizing a pick and place machine. This removal of multiple die from the substrate in a single pick and place transfer step allows for the die structures to be detached from the substrate forming the die of the present disclosure more quickly relative to other conventional methods of manufacturing.

While the above discussion is with respect to forming two die simultaneously, there may be more than two die coupled to the support structure that are removed simultaneously from the substrate by breaking multiple extension at substantially the same time. For example, three die structures may be coupled to the support structure that when the die structures are detached from the support structure by a pick and place machine at substantially the same time, three die are formed.

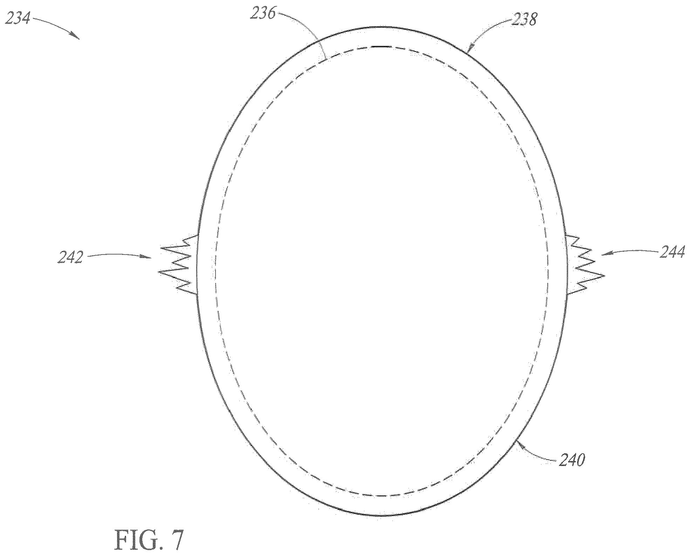

Figure 7 is a top-plan view of an embodiment of a third die 234 having curved or oval sidewalls. The third die 234 is formed by making the first recess 146 an oval shape, and the third die 234 may have an oval active area 236.

The third die 234 includes a first uniform surface 238 at the top side of the third die 234 and a second uniform surface 240 at the bottom side of the third die 234 based on the orientation as shown in Figure 7. The first and second uniform surfaces 238, 240 may be scalloped or smoother surfaces than a first irregular surface 242 and a second irregular surface 244. The first and second irregular surfaces 242, 244 separate the first uniform surface 238 from the second uniform surface 240. The first and second uniform surfaces 238, 240 and the first and second irregular surfaces 242, 244 are along a curved sidewall of the third die 234. Alternative shapes of the third die 234 may include circular shapes, ovular shapes, ellipsoidal shapes, or some other rounded shape.

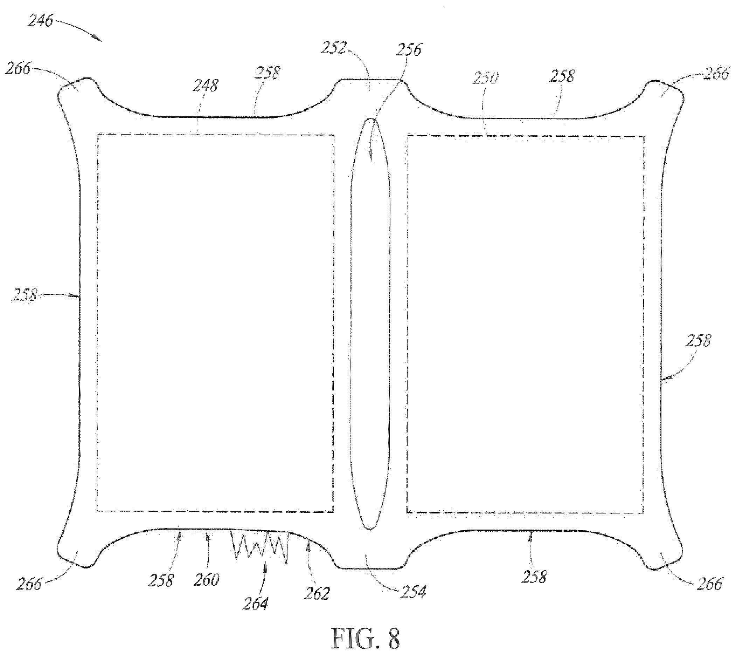

Figure 8 is a top-plan view of a fourth die 246 having a first active area 248 at the left-hand side of the fourth die 246 and second active area 250 on the right-hand side of the fourth die 246 based on the orientation as shown in Figure 8. The first active and the second active area 250 are substantially rectangular.

In Figure 8, the first and second active areas 248, 250 may be in electrical communication with each other. Electrical connections may extend through a first connection structure 252 at the upper side of the fourth die 246 and a second connection structure 254 at the lower side of the fourth die 246 based on the orientation as shown in Figure 8. The electrical connections may be conductive layers that extend through the first and second connection structures 252, 254 between the first and second active areas 248, 250, or the electrical connections may extend along surfaces of the first and second connection structures 252, 254 between the first and second active areas 248, 250.

The first connection structure 252 and the second connection structure 254 physically couple the first active area 248 to the second active area 250. The fourth die 246 further includes an opening 256 that extends from the first connection structure 252 to the second connection structure 254, and extends through the fourth die 246. The opening 256 may have a substantially oblong extended oval-like shape. Alternatively, the opening 256 may have a rectangular shape, a circular shape, trapezoidal shape, or any other suitable-type of shape. The first and second connection structures 252 may be referred to as extension portions, extension structures, or some other similar type of structure connecting the first and second active areas 248, 250.

The first active area 248 may be a light-receiving component (light sensor) and the second active area 250 may be a light-emitting component (e.g., light emitting diode). The light-receiving component may receive light emitted from the light-emitting component that has reflected off an object external to the fourth die 246. In other words, the light-emitting component and the light-receiving component may be time-of-flight (TOF) sensor or some type of proximity sensor such that the fourth die 246 is a TOF die or some type of proximity or distance sensor.

Alternatively, the first active area 248 and the second active area 250 may not work together. For example, the first active area 248 may be a pressure sensor and the second active area 250 may be a temperature sensor, which are not in electrical communication with each other. By adjusting the manufacturing method as discussed earlier with respect to Figures 1A-1F, dice such as the fourth die 246 may be formed being able to perform complex functions such as time-of-flight operations or may be able to perform multiple types of sensing functions (e.g., pressure, temperature, humidity, etc.).

The first and second connection structures 252, 254 may be broken to separate the first active area 248 from the second active area forming two die. This forms irregular textured surfaces at locations corresponding to the first and second structure on the two die.

The fourth die 246 further includes a plurality of curved sidewalls 258 having scalloped surfaces similar to those discussed earlier within the present disclosure. The sidewall at the bottom left-hand corner of the fourth die 246 includes a first uniform surface 260 (e.g., scalloped surface), a second uniform surface 262 (e.g., scalloped surface), and an irregular surface 264 between the first uniform surface 260 and the second uniform surface 262. The irregular surface 264 is formed in a similar manner as the irregular surface 188 of the first die 184 as discussed with respect to Figures IE and IF. Alternatively, irregular surfaces 264 may also be present at other ones of the curved surfaces as shown in Figure 8.

A plurality of protrusions 266 may be present at corresponding corners of the fourth die 246. The plurality of protrusions 266 are between ones of the curved sidewalls 258. For example, the protrusion 266 at the upper left-hand corner of the fourth die 246 is between the curved sidewall 258 at the left-hand side of the fourth die 246 and the curved sidewall 258 at the left top side of the fourth die 246 based on the orientation as shown in Figure 8. The plurality of protrusions 266 may be mounting components utilized to mount the fourth die 246 to a printed circuit board (PCB) or within an electronic device *(e.g.,* a computer, a smartphone, a smart tablet, a memory, etc.). The plurality of protrusion 266 may be standoff components utilized to support the fourth die 246 when coupled to the PCB.

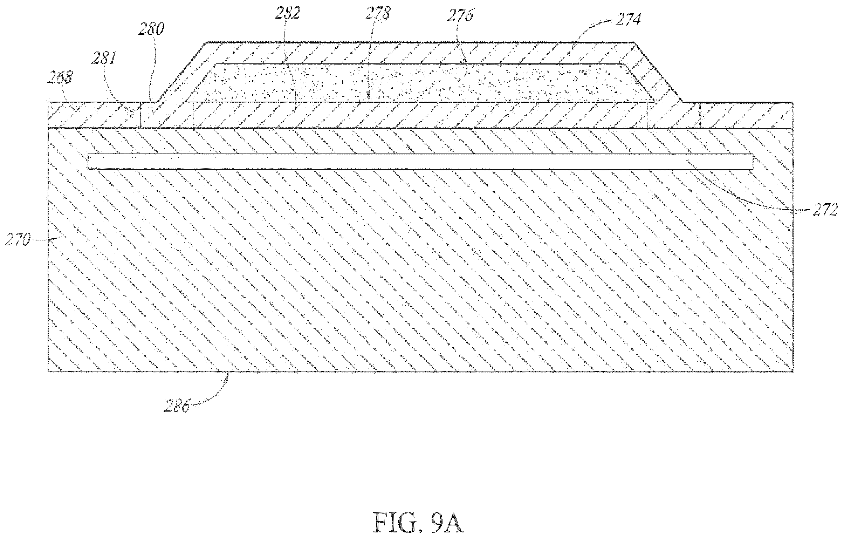

Figures 9A-9C are directed an alternative solutions of a method of manufacturing a micro-electromechanical systems (MEMS) die, which may include a membrane for a microphone.

A multilayer structure 268 is formed on a substrate 270, like a wafer. The substrate 270 includes a first cavity 272. The multilayer structure 268 is formed to include a membrane 274 having a support layer 276 positioned between the membrane 274 and a surface 278. The support or sacrificial layer 276 may be a temporary layer that is later dissolved or deteriorated by a chemical, which may be in gaseous or vapor form. For example, the support material may be an oxide material.

The multilayer structure 268 may be formed in a similar manner as the multilayer structure 108 as discussed with respect to Figures 1A and 1B. The multilayer structure 268 includes an active area 280 including active components surrounded by a scribe area 281. A sacrificial area 282 is surrounded by the active area 280. The scribe area 281 and the sacrificial area 282 do not include components that will be present in the completed MEMS die.

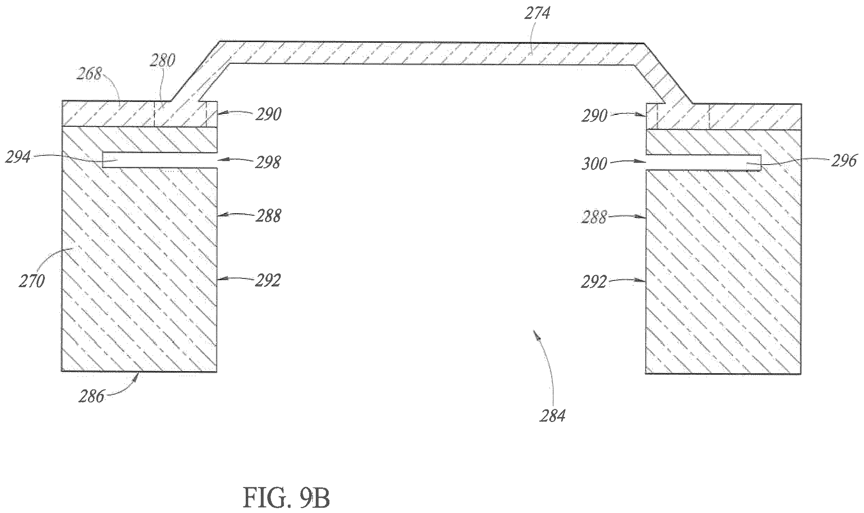

After the multilayer structure 268 is formed on the substrate 270, a backside removal process is performed based on the orientation as shown in Figure 9B. A second cavity 284 is formed extending into a back surface 286 at the bottom of the substrate 270. The backside removal process may be an etching process in which a mask layer is formed and patterned on the backside to expose an area of the back surface 286 corresponding to the second cavity 284.

The second cavity 284 is then formed by exposing the exposed area of the back surface 286 of the substrate 270 to an etching chemical.

The second cavity 284 extends through the substrate 270 and through the multilayer structure 268 to the support layer 276 exposing the support layer 276. The second cavity 284 may be formed utilizing a deep etching technique similar to forming the recesses 146, 148 as discussed earlier with respect to Figures 1C and 1D.

The second cavity 284 has sidewalls 288 that surround the second cavity 284. The sidewalls 288 include respective sidewalls 290 of the multilayer structure 268 and respective sidewalls 292 of the substrate 270.

The sidewalls 290 of the multilayer structure 268 and respective sidewalls 292 of the substrate 270 may be substantially coplanar and flush with each other.

A first portion 294 of the first cavity 272 is present on the left-hand side of the second cavity 284, and a second portion 296 of the first cavity 272 is present on the right-hand side of the second cavity 284. The first and second portions 294, 296 of the first cavity 272 are formed by forming the second cavity 284 extending through the substrate 270. The first portion 294 includes a first opening 298 substantially coplanar and flush with the respective sidewall 292 of the substrate 270 at the left-hand side of the second cavity 284. The second portion 296 includes a second opening 300 substantially coplanar and flush with the respective sidewall 292 of the substrate 270 on the right-hand side of the second cavity 284. The first and second openings 298, 300 are in fluid communication with the second cavity 284.

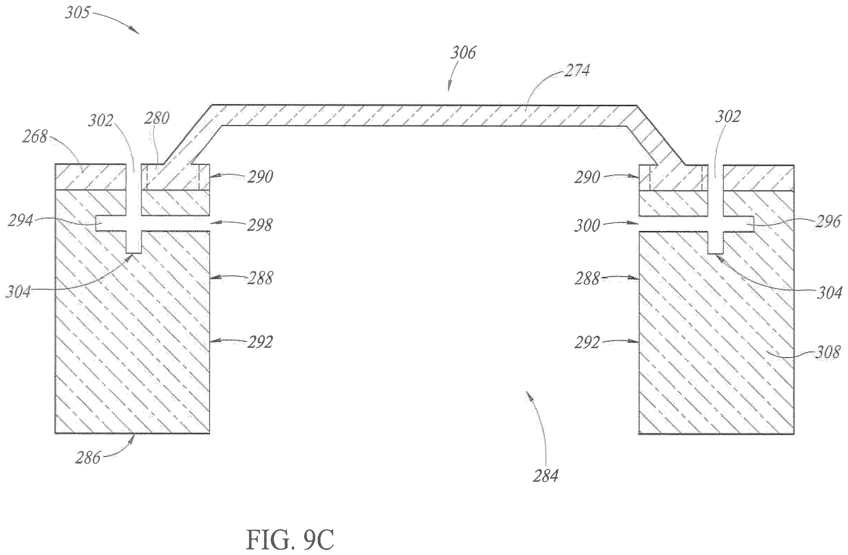

After the second cavity 284 exposes the support layer 276, the support layer 276 is removed. For example, the support layer 276 may be deteriorated by exposing the support layer 276 to an etching chemical that only deteriorates (e.g., dissolves) the support layer 276 without deteriorating other layers of the multilayer structure 268 or the substrate 270. This releases the membrane 274 to operate and move. In the alternative, the sacrificial layer is deteriorated at a later stage such that the support layer 276 continues to support the membrane 274 during further processing steps such as in a next step as shown in Figure 9C.

According to §figure 9C, after the second cavity 284 is formed and the support material has been deteriorated, a recess or opening 302 is formed extending into the scribe area 281 of the multilayer structure 268 to the first cavity 272. The recess 302 surrounds a majority of the active area 280 and the membrane 274. The recess 302 includes a termination end 304 within the substrate 270 and extends past the first cavity 272 within the substrate 270.

Figure 9C illustrates a die structure assembly 305 including a micro-electromechanical system (MEMS) die 306 and a suspension structure 308. At least one extension (not shown) extends from the MEMS die structure 306 to the suspension structure 308. The extension is the same as or similar to the extensions 180, 182 as described earlier with respect to Figures 1C and 1D. The at least one extension couples the MEMS die structure 306 to the suspension structure 308 and suspends the MEMS die structure 306 above the first and second portions 294, 296 of the first cavity 272 and the second cavity 284. The at least one extension may include portions of the substrate 270 and the multilayer structure 268. For example, the at least one extension may include a portion of the multilayer structure 268 stacked on a portion of the substrate 270.

After the recess 302 is formed, which also forms the at least one extension similar to how the first and second extensions 180, 182 are formed as described earlier with respect to Figures 1C and 1D, the MEMS die structure 306 may be released from the suspension structure 308. The MEMS die structure 306 may be released by breaking the at least one extension utilizing a pick-and-place machine similar to how the first and second extensions 180, 182 are broken as described earlier with respect to Figures 1C and 1D. A completed MEMS die is formed by releasing the MEMS die structure 306 from the suspension structure 308. The completed MEMS die may be a MEMS microphone, a MEMS pressure sensor, a MEMS sound sensor, or some other type of MEMS die or sensor that utilizes a membrane.

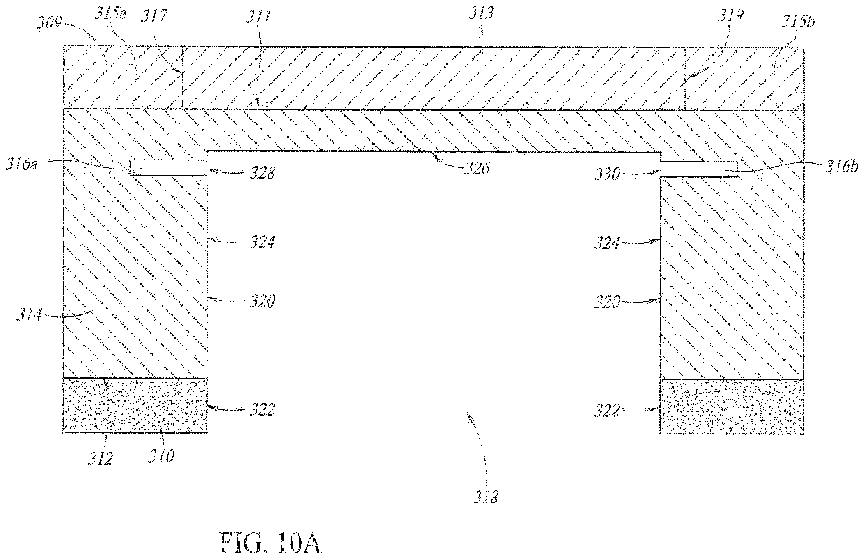

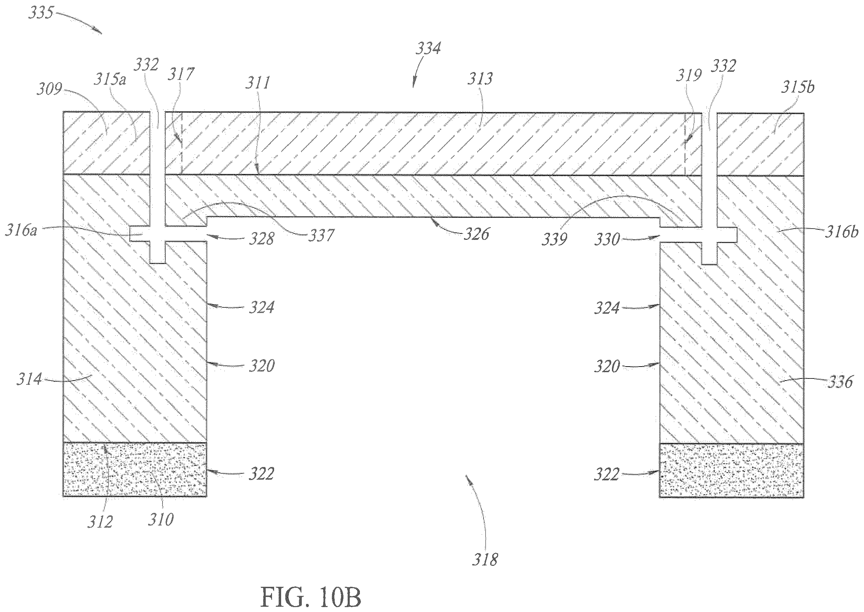

Figures 10A and 10B are directed to an alternative method of manufacturing a die. In this method of manufacturing, a multilayer structure 309 is formed on a first surface 311 of a substrate 314.

After the multilayer structure 309 is formed, a mask layer 310 is formed on a second surface 312 of a substrate 314 opposite to the first surface 311.

The substrate 314 may be a wafer. The substrate 314 includes a first cavity 316a, 316b pre-formed in the substrate 314. For example, the first cavity 316a, 316b may be pre-formed in the substrate 314 before multilayer structure and the mask layer 310 are formed on the substrate 314.

The multilayer structure includes an active area 313 and a scribe area 315a, 315b that surrounds the active area. The scribe area includes a first portion 315a on the left-hand side of the active area adjacent to a first end 317 of the active area, and a second portion 315b on the right-hand side of the active area adjacent to a second end 319 of the active area. The scribe areas may be kerf areas, frame areas, or some other type of sacrificial areas that do not include layers or electrical components to be present in a completed semiconductor die.

After the mask layer 310 is formed on the second surface 312, the mask layer 310 is patterned exposing areas of the second surface 312 of the substrate 314 from the mask layer 310. An etching chemical is then applied to the exposed area of the second surface 312 etching away a portion of the substrate 314 forming a second cavity 318 having sidewalls 320.

Sidewalls 320 of the second cavity 318 include respective sidewalls 322, 324 of the mask layer 310 and the substrate 314 that are coplanar and flush with each other.

The second cavity 318 extends through the first cavity 316a, 316b forming an indentation 326 in the substrate 314 between a first portion 316a and second portion , 316b of the first cavity 316a, 316b. The indentation 326 terminates before reaching the first surface 311 of the substrate 314. The second cavity 318 extends through the first cavity 316a, 316b forming the first portion 316a of the first cavity 316a, 316b on the left-hand side and the second portion 316b of the first cavity 316a, 316b on the right-hand side. The second cavity 318 terminates before reaching the first surface 311 of the substrate 314.

A first opening 328 of the first portion 316a of the first cavity 316a, 316b is at the sidewall 324 of the substrate 314 on the left-hand side of the second cavity. A second opening 330 of the second portion 316b of the first cavity 316a 316b is at the sidewall 324 of the substrate 314 on the right-hand side of the second cavity. The first and second openings 328, 330 are in fluid communication with the second cavity 318 and are substantially coplanar and flush with the respective sidewalls 324 of the substrate 314.

In Figure 10B, after the second cavity 318 is formed, a recess 332 is formed extending through the multilayer structure and into the substrate 314. The recess 332 forms a die structure 334 and a suspension structure 336 surrounding the die structure 334. A die structure assembly 335 includes the die structure 334 and the suspension structure 336. The die structure 334 may be a central structure and the suspension structure 336 may be a peripheral structure. The die structure 334 is coupled to the suspension structure 336 by an extension (not shown) similar to the extensions 180, 182 as discussed with respect to Figures 1C and 1D earlier within the present disclosure.

A first protrusion 337 and a second protrusion 339 are formed by forming the recess 332. The first protrusion is at the left-hand side of the indentation 326 and the second protrusion is at the right-hand side of the indentation 326. The first protrusion is at the left-hand side of the die structure 334, and the second protrusion is at the right-hand side of the die structure 334. The first and second protrusion 337, 339 may act as spacers or standoffs for a die when the die is mounted to an electronic component such as a printed circuit board (PCB). The die is formed by releasing the die structure from the suspension structure in a similar manner as discussed earlier with respect to Figures IE and IF. However, in an alternative method, the die structure 313 may remain coupled to the suspension structure 336 after the recess 332 is formed for further processing steps before the die structure 313 is released from the suspension structure 336 forming a die.

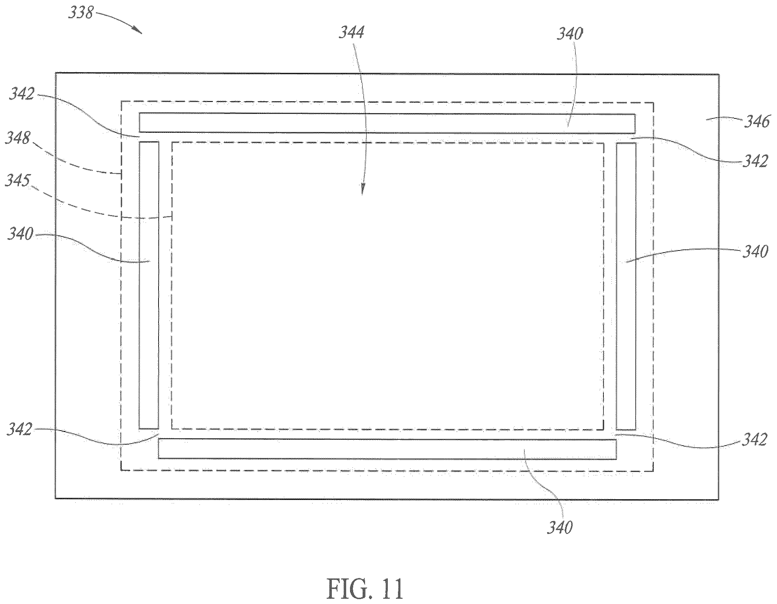

Figure 11 is a top plan view of a die structure assembly 338 including a plurality of recesses 340 and a plurality of extensions 342 positioned between adjacent ones of the plurality of recesses 340. The plurality of recesses 340 could all of similar size and shape relative to each other. In the alternative, the plurality of recesses 340 may be of different size and shape relative to each other.

The plurality of extensions 342 extend across the plurality of recesses 340 coupling a die structure 344 to a suspension structure 346. The die structure 344 includes an active area 345. The extensions 342 are quasi-release structures that are to be broken to release or break away the die structure 344 from the suspension structure 346. Each one of the plurality of extensions 342 is at a corresponding corner of the die structure 344. When the extensions 342 are broken the die structure 344 is released from the suspension structure 346 and a die is formed.

While only a single die structure 344 is shown in this die structure assembly 338, it will be readily appreciated that the plurality of recesses 340 may substitute and replace the first recess 146 and the second recess 148 as shown in Figures 1C and 1D when forming multiple completed die from a wafer. For example, a plurality of first recesses 340 may surround the first die structure 162 and a plurality of second recesses 340 may surround the second die structure 164 as shown in Figures 1C and 1D having patterns similar to as shown in Figure 11.

The die structure assembly 338 further includes a cavity 348 in fluid communication with the plurality of recesses 340. The cavity 348 is surrounded by a dotted line and the dotted line is representative of an outer edge of the cavity 348. The cavity 348 is a pre-formed cavity similar to the other pre-formed cavities as described earlier within the present disclosure.

Figure 12 is a top plan view of a die structure assembly 350 including a plurality of recesses 352 and a plurality of extensions 354 positioned between adjacent ones of the plurality of recesses 352. Here, the plurality of recesses 352 are different sizes relative to each other. In the alternative, the plurality of recesses 352 are all of similar size and shape relative to each other.

The plurality of extensions 354 extend across the plurality of recesses 352 coupling a die structure 356 to a suspension structure 358. The die structure 356 includes an active area 360. The extensions 354 are quasi-release structures that are to be broken to release or break away the die structure 356 from the suspension structure 358. When the extensions 354 are broken the die structure 356 is released from the suspension structure 358 and a die is formed.

While only a single die structure 356 is shown in this die structure assembly 350, it will be readily appreciated that the plurality of recesses 352 may substitute and replace the first recess 146 and the second recess 148 as shown in Figures 1C and 1D when forming multiple die from a wafer. For example, a plurality of first recesses 352 may surround the first die structure 162 and a plurality of second recesses 352 may surround the second die structure 164 as shown in Figures 1C and 1D having a pattern similar to that shown in Figure 12.

The die assembly structure 356 further includes a cavity 362 in fluid communication with the plurality of recesses. The cavity 362 is surrounded by a dotted line and the dotted line is representative of an outer edge of the cavity 362. The cavity 362 may be a pre-formed cavity similar to the other pre-formed cavities as described earlier in the present disclosure.

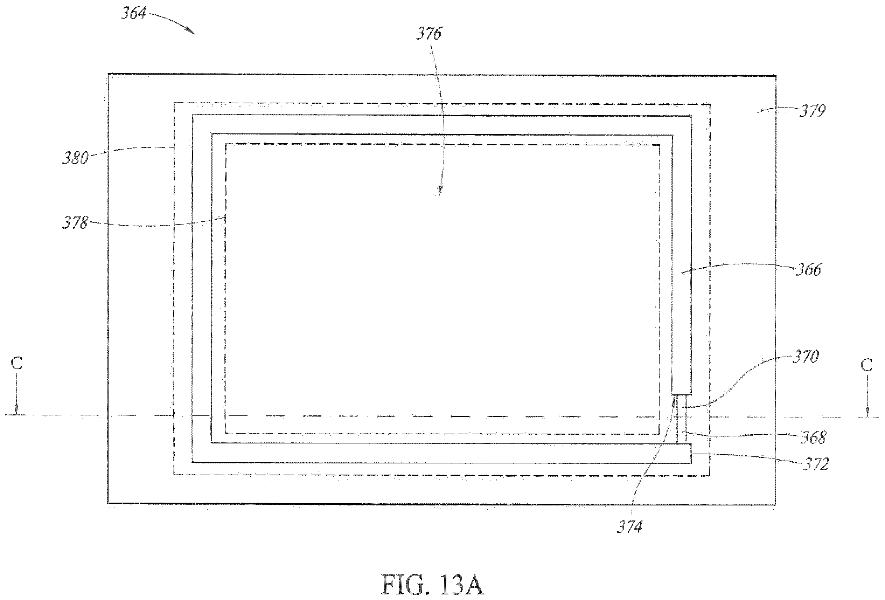

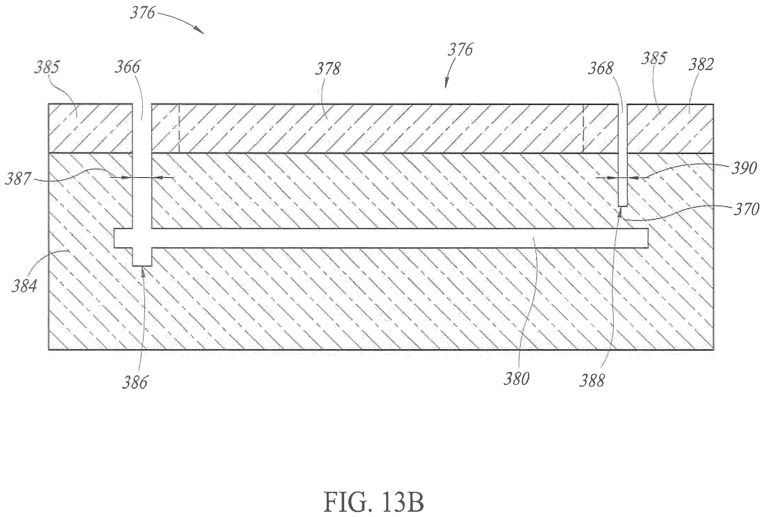

Figures 13A and 13B show a die structure assembly 364 including a first recess 366, a second recess 368 that is smaller than the first recess 366, and an extension 370 aligned with the second recess 368 and positioned between ends 372, 374 of the first recess 366. Figure 13A is a top plan view of the die structure assembly 364, and Figure 13B is a cross-sectional view of the die structure assembly 364 taken along line C-C as shown in Figure 13A.

The first recess 366 surrounds a majority of a die structure 376, which includes an active area 378. The second recess 368 extends from a first end 372 of the first recess 366 to a second end 374 of the first recess 366. The second recess 368 separates the first end 372 from the second end 374 of the first recess 366.

The extension 370 (see also Figure 13B) extends from the first end 372 of the first recess 366 to the second end 374 of the first recess 366. The extension 370 extends from the die structure 376 to a suspension structure 379 such that the die structure 376 is coupled to the suspension structure. The extension 370 suspends the die structure 376 over a cavity 380, which is in fluid communication with the first recess 366 and the second recess 368 through the first recess 366. The cavity 380 is a pre-formed cavity similar to the other pre-formed cavities as described earlier in the present disclosure. The extension 370 is a quasi-release structure that is to be broken to release or break away the die structure 376 from the suspension structure 379. When the extension 370 is broken, the die structure 376 is released from the suspension structure and a die is formed.

As shown in Figure 13B, the die structure assembly 364 includes a multilayer structure 382 including the active area 378, and a substrate 384 including the cavity 380. The first and second recesses 366, 368 extend through scribe areas 385 of the multilayer structure 382. The scribe areas 385 may be kerf areas, frame areas, or some other type of sacrificial areas that do not include layers or electrical components to be present in the completed semiconductor die.

The first recess 366 extends through the multilayer structure 382 and extends past the cavity 380 within the substrate 384. The first recess 366 includes a first termination end 386 extending beyond the cavity 380. The first recess 366 includes a first dimension 387 that extends between opposite sidewalls of the first recess.

The second recess 368 extends through the multilayer structure 382 and the substrate 384. However, unlike the first recess 366, the second recess 368 terminates within the substrate 384 before reaching the cavity 380. The second recess 368 includes a second termination end 388 that terminates within the substrate 384 before the second recess 368 reaches the cavity 380. The second recess 368 includes a second dimension 390 that extends between opposite sidewalls of the second recess 368. The second dimension 390 is less than the first dimension 387. In some other embodiments, the second dimension 390 may substantially equal to the first dimension 387 or the second dimension 390 may be greater than the first dimension 387.

The first recess 366 is formed by performing a first deep etching process to form the first recess 366. After the first recess 366 is formed, the second recess 368 is formed by a second deep etching process following the first deep etching process. In the alternative, the first deep etching process may follow the second deep etching process.

While the first and second deep etching processes form the first and second recesses 366, 368, the first and second deep etching processes also define the extension 370 by forming the first and second recesses 366, 368.

While only a single die structure 376 is shown in this die structure assembly 364, it will be readily appreciated that the first and second recesses 366, 368 as shown in Figures 13A and 13B may substitute and replace the first recess 366 and the second recess 368 as shown in Figures 1C and 1D when forming multiple die from a wafer.

Figure 14 is a cross-sectional view of a die structure assembly 400 including a die structure 402 and a suspension structure 404. The die structure 402 is coupled to the suspension structure 404 and is suspended above a cavity 406 positioned between the die structure 402 and the suspension structure 404. A recess 408 surrounds the majority of the die structure 402 similar to the first recess 146 as shown in Figures 1C and 1D. In figure 14, the die structure 402 is coupled to the suspension structure 404 by an extension (not shown), which may the same or similar to the extension as shown in Figures 1C and 1D, that extends across the recess 408 and the cavity 406 coupling the die structure 402 to the suspension structure 404. The extension suspends the die structure 402 above the cavity 406 based on the orientation as shown in Figure 14. The extension is a quasi-release structure that is broken to release the die structure 402 from the suspension structure 404 to form a die.

The die structure 402 includes a first doped region 410 and a second doped region 412 stacked on the first doped region 410. For example, here, the first doped region 410 is a p-doped region such as a p-doped substrate layer and the second doped region 412 is an n-doped region such as an n-doped buried layer. The first doped region 410 is formed on the second doped region 412 such that the second doped region 412 is stacked on the first doped region 410.

The first doped region 410 covers here sidewalls of the first doped region 410.

After the second doped region 412 is formed on the first doped region 410, a third doped region 414 is formed on the second doped region 412. The third doped region 414 may be a doped epitaxial region such as a doped epitaxial layer. For example, here, the third doped region 414 is a p-doped region such as a p-doped epitaxial layer.

After the third doped region 414 is formed on the second doped region 412, a plurality of first doped wells 416, a plurality of second doped wells 418, and a plurality of third doped wells 420 are formed extending into the third doped region 414. The plurality of first doped wells 416 extend into the third doped region 414 to the second doped region 412 such that the plurality of first doped wells 416 contact the first doped region 410. For example, the plurality of first doped wells 416 are n-doped wells.

Ones of the plurality of first doped wells 416 may be at the sidewalls of the second doped region 412 such that the ones of the plurality of first doped wells 416 contact the first doped region 410. For example, here, the first doped well on the right-hand side of the die structure 402 and the first doped well on the left-hand side of the die structure 402 contact both the first and second doped regions 410, 412.

One of the plurality of first doped wells 416 may separate a first portion and a second portion of the third doped region 414. For example, the third first doped well at a center of the die structure 402 may separate the left-hand side of the third doped region 414 from the right hand side of the third doped region 414 based on the orientation as shown in Figure 14.

The plurality of second doped wells 418 and the plurality of third doped wells 420 extend into the third doped region 414 and terminate within the third doped region 414 before reaching the second doped region 412. For example, the plurality of second doped wells 418 are n-doped wells and the plurality of third doped wells 420 are p-doped wells.

A plurality of isolation regions 421, which are non-conductive or insulating regions, are formed on the pluralities of first, second, and third doped wells 420. After the plurality of isolation regions are formed, a plurality of fourth doped regions 422 are formed on the pluralities of first, second, and third doped wells 420.

The plurality of isolation regions separate adjacent ones of the plurality of fourth doped regions 422. Some of the plurality of fourth doped regions 422 may be n-type doped fourth regions and some of the plurality of fourth doped regions 422 may be p-type doped fourth regions.

Ones of the plurality of fourth doped regions 422 are in electrical communication with other ones of the plurality of fourth doped regions 422. For example, here, at the left-hand side of the die structure 402, two of the fourth doped regions 422 *(e.g.,* one n-type and one p-type) are in electrical communication with each other such that they act as an anode 424, and at the right-hand side of the die structure 402, two of the fourth doped regions 422 *(e.g.,* one n-type and on p-type) are in electrical communication with each other such that they act as a cathode 426. Other ones centrally located in the die structure 402 may form electrical pathways 428 *(e.g.,* electrical connections) along which electrical signals may pass along and through the various doped regions from the cathode 426 to the anode 424. The anode 424 and the cathode 426 may be electrodes.

In Figure 14, the fourth doped regions 422 and the isolation regions are exposed at a surface 430 of a substrate 432 of the die structure 402 facing away from the cavity 406 within the suspension structure 404. In the alternative , a multilayer structure may be formed on the surface 430 of the substrate such that the doped regions are on the surface 430 of the die structure 402. The multilayer structure is similar to the multilayer structures as described earlier.

The doped regions and the doped wells of the die structure 402 may be doped with different types of dopants. These different types of dopants have different conductivities such that the doped region and the doped wells work together and function as a number of transistors within the die structure 402 to perform complex logic functions. For example, the doped regions and the doped wells of the die structure 402 may form a complementary metal-oxide-semiconductor (CMOS) die, which may be a microprocessor die, a memory die, a microcontroller die, or some other integrated circuit die.

The above doped regions, doped wells, and isolation regions may be formed by depositing the doped regions or doping the doped regions with techniques known to the semiconductor industry. For example, some formation techniques may include deposition techniques such as sputtering, vapor deposition, or some other deposition formation technique. For example, some doping techniques may include diffusion techniques or ion-implantation techniques. Diffusion techniques may include gas-phase diffusion techniques, solid-source diffusion techniques, or liquid-phase diffusion techniques.

A device may be summarized as including a die including a first surface; a second surface opposite to the first surface; and a first sidewall transverse to the first and second surfaces, the first sidewall including a third surface and a fourth surface, the fourth surface having a more irregular texture than the third surface.

The die may further include a dimension extending from the first surface to the second surface, and the dimension is less than or substantially equal to 10-µm (micrometers). The first sidewall may have the dimension and the first sidewall extends from the first surface to the second surface.

The first sidewall may further include a sixth surface having a more irregular texture than the third surface. The third surface may be scalloped having a plurality of first points closer to a centerline of the die than a plurality of second points, ones of the plurality of second points being between adjacent ones of the plurality of first points.

The die may further include a second sidewall transverse to the first and second surfaces and transverse to the first sidewall, the second sidewall having a seventh surface and an eighth surface, the eighth surface having a more irregular texture than the seventh surface. The third surface may have a first surface area, and the fourth surface may have a second surface area different from the first surface area. The third surface may have a first surface area, and the fourth surface may have a second surface area substantially equal to the first surface area. The first sidewall may be curved. The first and second surfaces may be n-gon shapes. The first and second surfaces may be circular shapes. The first and second surfaces may be oval shapes. The first and second surfaces may be elliptical shapes.

The die may further include a first portion; a second portion; an opening extending into the die between the first portion and the second portion; a first extension portion extending from the first portion to the second portion; and a second extension portion extending from the first portion to the second portion, the second extension portion spaced apart from the first portion by the opening.

The opening may be an elliptical shape. The die may include a membrane at the first surface of the die.

The die may further include an edge; an active portion; and a non-active boundary portion around the active portion, the non-active boundary portion extending from the edge to the active portion, the non-active boundary portion separating the edge from the active portion.

A device may be summarized as including a substrate; a die in the substrate; a first extension portion extending from a first sidewall of the substrate to a second sidewall of the die, the first extension portion coupling the die to the substrate, and the first extension portion including a first portion of a material continuous with the die and the substrate; and a first recess between the first sidewall and the second sidewall.

The device may further include a cavity in fluid communication with the first recess and between a first surface of the substrate and a second surface of the die, the first and second surfaces transverse to the first and second sidewalls.

The device may further include a second extension portion separate and distinct from the first extension portion, the second extension portion extending from first sidewall to the second sidewall, and the second extension portion including a second portion of the material continuous with the die and the substrate. The first recess may extend from the first extension portion to the second extension portion.

The device may further include a second recess between the die and the substrate.

The device may further include a cavity in fluid communication with the first recess and between a first surface of the substrate and a second surface of the die, the first and second surfaces transverse to the first and second sidewalls.

The device may further include a second extension portion separate and distinct from the first extension portion, the second extension portion extending from a third sidewall of the substrate and a fourth sidewall of the die, the third and fourth sidewalls being transverse to the first and second sidewalls, the second extension portion couples the die to the substrate, and the second extension portion including a second portion of the material continuous with the die and the substrate. The first recess may extend from the first extension portion to the second extension portion.

The device may further include a second recess between the die and the substrate.

The device may further include a cavity in fluid communication with the first recess and the second recess, the cavity is between a first surface of the substrate and a second surface of the die, the first and second surfaces being transverse to the first and second sidewalls. The recess may extend around the die in the substrate.

The die may further include a first surface; a second surface opposite to the first surface, the second sidewall extending from the first surface to the second surface; an active portion at the first surface; and an inactive portion extending from the first recess to the active portion, the inactive portion spacing apart the active portion from the recess.

The first recess may be aligned with and overlaps the first extension portion.

The device may further include a second recess between the first sidewall of the die and the second sidewall of the die, the second recess overlapping the first extension portion.

The device may further include a cavity in fluid communication with the first recess and between a first surface of the substrate and a second surface of the die, the first and second surfaces being transverse to the first and second sidewalls. The first recess may extend into the substrate to the cavity, and the second recess may extend into the substrate and terminates within the substrate before the cavity. The first extension portion may be between the second recess and the cavity, the first extension separating the second recess from the cavity.

A method may be summarized as including forming a die from a substrate including forming a first sidewall of the die including forming a first surface of the first sidewall, and forming a second surface of the first sidewall having a more irregular texture than the first surface.

Forming the die from the substrate may further include forming a second sidewall of the die including forming a third surface of the second sidewall, and forming a fourth surface of the second sidewall having a more irregular texture than the third surface. Forming the first surface may include forming the first surface having a first surface area; forming the second surface may include forming the second surface having a second surface area different from the first surface area; forming the third surface may include forming the third surface having a third surface area; and forming the fourth surface may include forming the fourth surface having a fourth surface area different from the first surface area. Forming the first surface may include forming the first surface having a first surface area; forming the second surface may include forming the second surface having a second surface area substantially equal to the first surface area; forming the third surface may include forming the third surface having a third surface area; and forming the fourth surface may include forming the fourth surface having a fourth surface area substantially equal to the first surface area.

Forming the first surface of the first sidewall may further include forming the first surface having a first surface area; and forming the second surface of the first sidewall may further include forming the second surface having a second surface area different from the first surface area.

Forming the first surface of the first sidewall may further include forming the first surface having a first surface area, and forming the second surface of the first sidewall may further include forming the second surface having a second surface area substantially equal to the first surface area. Forming the first surface may include forming a recess between the substrate and the die.

The method may further include forming an extension portion extending from the substrate to the die across the recess.

Forming the second surface may further include breaking the extension portion separating the die from the substrate.

Forming the second surface may further include separating the die from the substrate. Separating the die from the substrate may include breaking the die apart from the substrate.

A method may be summarized as including forming a suspended portion at a first surface of a substrate including forming a first extension portion coupling the suspended portion to the substrate by forming a first recess extending into a first surface of a substrate to a cavity between a second surface of the substrate and a third surface of the suspended portion.

The method may further include separating the suspended portion from the substrate. Separating the suspended portion from the substrate may include breaking the first extension portion.

Forming the first extension portion may further include forming a second recess extending into the first surface of the substrate to the cavity.

The method may further include forming a second extension portion coupling the suspended portion to the substrate by forming the second recess and by forming a third recess extending into the substrate to the cavity.

Forming the first extension portion may further include forming the first extension portion between the cavity and the first surface of the substrate by forming a second recess extending into the substrate terminating within the substrate before reaching the cavity.

Forming the second recess may further include aligning the second recess with the first extension portion.

A device may be summarized as including: a die including a first surface, a second surface opposite to the first surface, and a first sidewall transverse to the first and second surfaces, the first sidewall including a third surface and a fourth surface, the fourth surface having a more irregular texture than the third surface.

The die may further include a dimension extending from the first surface to the second surface, and the dimension is less than or substantially equal to 10-µm (micrometers). The first sidewall may have the dimension and the first sidewall extends from the first surface to the second surface.

The die may further include a second sidewall transverse to the first and second surfaces and transverse to the first sidewall, the second sidewall having a fifth surface and a sixth surface, the sixth surface having a more irregular texture than the fifth surface.

The third surface may have a first surface area, and the fourth surface may have a second surface area smaller than the first surface area.

The first sidewall of the die may be curved.

The die may further include a first portion, a second portion, an opening extending into the die between the first portion and the second portion, a first extension portion extending from the first portion to the second portion, and a second extension portion extending from the first portion to the second portion, the second extension portion spaced apart from the first portion by the opening.

The die may include a membrane at the first surface of the die.

The die may further include: an edge, an active portion closer to the first surface than the second surface, and a non-active boundary portion around the active portion, the non-active boundary portion extending from the edge to the active portion, the non-active boundary portion separating the edge from the active portion.

A method may be summarized as including: forming a die from a substrate having a cavity buried in the substrate, the forming the die including: forming a first sidewall of the die by forming a first surface of the first sidewall by forming a recess through the substrate to the cavity, and forming a second surface of the first sidewall having a more irregular texture than the first surface by detaching the die from the substrate.

Forming the die from the substrate may further include: forming a second sidewall of the die including: forming a third surface of the second sidewall, and forming a fourth surface of the second sidewall having a more irregular texture than the third surface. Forming the first surface may include forming the first surface having a first surface area. Forming the second surface may include forming the second surface having a second surface area different from the first surface area. Forming the third surface includes forming the third surface having a third surface area. Forming the fourth surface includes forming the fourth surface having a fourth surface area different from the third surface area.

The method may further include forming an extension portion extending from the substrate to the die across the recess.

A method may be summarized as including: forming a suspended electrode at a first surface of a die that includes an active area coupled to the suspended electrode, forming a first extension portion coupling the suspended electrode to a substrate by forming a first recess extending into the first surface to a buried cavity in the substrate, and forming a first irregular side surface by releasing the die from the substrate by decoupling the first extension portion from the substrate, the first irregular side surface being less uniform than a second side surface that is adjacent to the first irregular side surface.

Decoupling the first extension portion from the substrate may include breaking the first extension portion.

Forming the first extension portion further may include forming a second recess extending into the substrate to the cavity.

A device may be summarized as including: a semiconductor die having an active surface, a passive surface, and a first sidewall surface between the active surface and the passive surface, the first sidewall surface includes a first dimension that is less than 20 micrometers, the first sidewall surface includes: a first portion having a uniform surface texture; and a second portion having a non-uniform surface texture, the second portion having a smaller surface area than the first portion.

The first sidewall surface may be curved.

The first sidewall surface may include a third portion having a non-uniform surface texture, the non-uniform surface texture of the second and third portion having irregular peaks and valleys.

The semiconductor die may include a second sidewall surface transverse to the first sidewall surface, the second sidewall surface includes: a third portion having a uniform surface texture, and a fourth portion having a non-uniform surface texture, the fourth portion having a smaller surface area than the third portion.

The various embodiments described above can be combined to provide further embodiments.

These and other changes can be made to the embodiments in light of the above-detailed description. In general, in the following claims, the terms used should not be construed to limit the claims to the specific embodiments disclosed in the specification and the claims, but should be construed to include all possible embodiments along with the full scope of equivalents to which such claims are entitled. Accordingly, the claims are not limited by the disclosure.

## Claims

1. A semiconductor device, comprising:
a die (184; 224; 234; 246) including:
a first surface (112);
a second surface (166) opposite to the first surface; and
a first sidewall (150; 228; 238, 240, 242, 244; 258) transverse to the first and second surfaces, the first sidewall including a third surface (186; 230; 238, 240; 260, 262) and a fourth surface (188: 232; 242, 244; 264), the fourth surface having a more irregular texture than the third surface.

2. The semiconductor device of claim 1, wherein the die (184; 224; 234; 246) further includes a dimension extending from the first surface (112) to the second surface (166; 240), and the dimension is less than or substantially equal to 10 µm.

3. The semiconductor device of claim 2, wherein the first sidewall (150; 228; 238, 240, 242, 244; 258) has the dimension and the first sidewall extends from the first surface (112) to the second surface (166; 240).

4. The semiconductor device of any of the preceding claims, wherein the die (184; 224; 234) further includes a second sidewall (228) transverse to the first and second surfaces and transverse to the first sidewall, the second sidewall having a fifth surface (230) and a sixth surface (232), the sixth surface having a more irregular texture than the fifth surface.

5. The semiconductor device of any of the preceding claims, wherein:
the third surface (186; 230; 238, 240; 260, 262) has a first surface area; and
the fourth surface (188: 232; 242, 244; 264) has a second surface area smaller than the first surface area.

6. The semiconductor device of claim 5, wherein the first sidewall (238, 240, 242, 244) is curved.

7. The semiconductor device of any of the preceding claims1, wherein the die (229; 246); further includes:
a first portion (248);
a second portion (250);
an opening (256) extending into the die between the first portion and the second portion;
a first extension portion (252) extending from the first portion to the second portion; and
a second extension portion (254) extending from the first portion to the second portion, the second extension portion spaced apart from the first portion by the opening.

8. The semiconductor device of any of the preceding claims, wherein the die (306) includes a membrane (274) at the first surface of the die.

9. The semiconductor device of claim 1, wherein the die (184; 224; 234;246) further includes:
an edge (150);
an active portion (116a; 225; 236; 248; 250; 280; 313) closer to the first surface (112) than the second surface (166); and
a non-active boundary portion (190) around the active portion, the non-active boundary portion extending from the edge to the active portion, the non-active boundary portion separating the edge from the active portion.

10. A method of manufacturing a semiconductor device, comprising;
forming a die (184; 224; 234; 246) from a substrate (100; 270; 314) having a cavity (110a, 110b; 272; 316a, 316b; 380) buried in the substrate, the forming the die including:
forming a first sidewall (150; 228; 238, 240, 242, 244; 258) of the die by:
forming a first surface (186; 230; 238, 240; 260, 262) of the first sidewall by forming a recess (146, 148; 302; 332, 340; 352; 366; 408) through the substrate to the cavity; and
forming a second surface (188: 232; 242, 244; 264) of the first sidewall having a more irregular texture than the first surface by detaching the die from the substrate.

11. The method of claim 10, wherein forming the die from the substrate further includes:
forming a second sidewall of the die including:
forming a third surface of the second sidewall; and
forming a fourth surface of the second sidewall having a more irregular texture than the third surface.

12. The method of claim 11, wherein:
forming the first surface includes forming the first surface having a first surface area;
forming the second surface includes forming the second surface having a second surface area different from the first surface area;
forming the third surface includes forming the third surface having a third surface area; and
forming the fourth surface includes forming the fourth surface having a fourth surface area different from the third surface area.

13. The method of claim 11 or 12, further comprising forming an extension portion (180, 182;342; 354) extending from the substrate (100; 270; 314) to the die across the recess.

14. The method of claim 13, comprising:
forming the second surface (188: 232; 242, 244; 264) by releasing the die (184; 224234; 246) from the substrate (100; 270; 314) by decoupling the extension portion (180, 182; 342; 354) from the substrate.

15. The method of claim 14, wherein decoupling the extension portion (180, 182; 252; 342; 354) from the substrate (100; 270; 314) includes breaking the extension portion.
